# EUROPEAN PATENT APPLICATION

(11) **EP 4 273 932 A1**
(43) Date of publication of application: **08.11.2023**
(21) Application number: 21929492.3
(22) Date of filing: 08.03.2021
(51) Int. Cl.: H01L 27/108

(54) **SEMICONDUCTOR APPARATUS, ELECTRONIC DEVICE, AND FORMING METHOD FOR TRANSISTOR**

(71) Applicant: Huawei Technologies Co., Ltd., Shenzhen, Guangdong 518129 (CN)
(72) Inventor: HUANG, Kailiang, Shenzhen, Guangdong 518129 (CN); JING, Weiliang, Shenzhen, Guangdong 518129 (CN); FENG, Junxiao, Shenzhen, Guangdong 518129 (CN); WANG, Zhengbo, Shenzhen, Guangdong 518129 (CN)
(74) Representative: Epping - Hermann - Fischer
(86) International application number: PCT/CN2021/079605
(87) International publication number: WO 2022/188010

(57) **Abstract**

Embodiments of this application provide a forming method for a semiconductor apparatus, an electronic device, and a transistor, and a forming method for a memory. The method relates to the field of memory technologies, which can improve an integration density of a memory cell. The semiconductor apparatus includes a substrate and a first transistor and a second transistor that are formed on the substrate. The second transistor is electrically connected to the first transistor, the first transistor and the second transistor are arranged along a first direction perpendicular to the substrate, and the first transistor and the second transistor each include a gate, a semiconductor layer, a first electrode, and a second electrode; and in either of the first transistor and the second transistor, the gate and the semiconductor layer are arranged along a second direction parallel to the substrate, and the first electrode and the second electrode are disposed on two sides of the semiconductor layer along the first direction and are electrically connected to the semiconductor layer respectively.

## Description

### TECHNICAL FIELD

This application relates to the field of memory technologies, and in particular, to a forming method for a semiconductor apparatus, an electronic device, and a transistor, and a forming method for a memory that can improve integration density.

### BACKGROUND

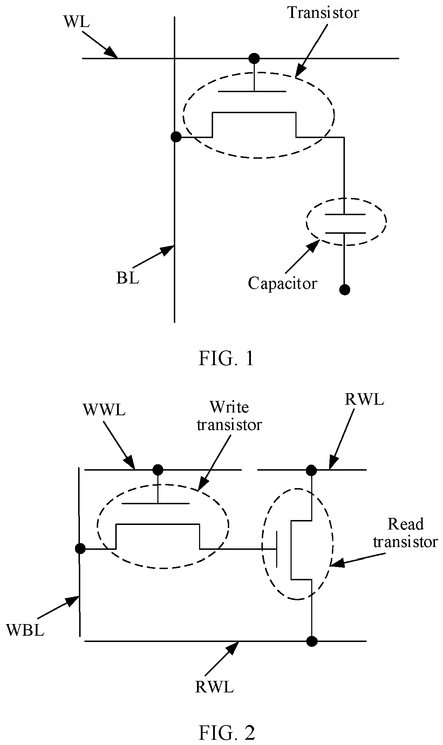

In a computing system, as a memory structure, a dynamic random access memory (DRAM) may be used to temporarily store computing data of a central processing unit (CPU) and exchange data with an external memory such as a hard disk, and is a very important part of the computing system. FIG. 1 shows a diagram of a structure of one memory cell in a DRAM. The memory cell includes a transistor and a capacitor that is electrically connected to the transistor, and the transistor is electrically connected to a bit line (BL) and a word line (WL), where the transistor is configured to control connection or disconnection between the BL and the capacitor, and the capacitor is configured to store a charge. The memory cell may be referred to as a 1T1C memory cell. 1T represents one transistor, and 1C represents one capacitor. During preparation of the memory cell, because the capacitor is restricted by a process condition, and it is difficult for the capacitor to continue to miniaturize without sacrificing a capacitance value, limiting further improvement of an integration density of the DRAM.

FIG. 2 shows a diagram of a structure of one memory cell in another DRAM. The memory cell includes two transistors. Compared with the 1T1C memory cell shown in FIG. 1, there is not a capacitor in the memory cell shown in FIG. 2. The memory cell thus formed may be referred to as a 2T0C memory cell. Compared with the 1T1C memory cell shown in FIG. 1, the 2T0C memory cell shown in FIG. 2 has a correspondingly higher operating speed when equivalent memory capacity is ensured. Therefore, a memory having the 2T0C memory cell is widely studied. Two transistors in the 2T0C memory cell shown in FIG. 2 may be referred to as a write transistor and a read transistor, and a gate of the write transistor is electrically connected to a write word line (WWL). One of a source and a drain of the write transistor is electrically connected to a write bit line (WBL), and the other of the source and the drain of the write transistor is electrically connected to a gate of the read transistor. One of a source and a drain of the read transistor is electrically connected to a read word line (RWL), and the other of the source and the drain of the read transistor is electrically connected to a read bit line (RBL).

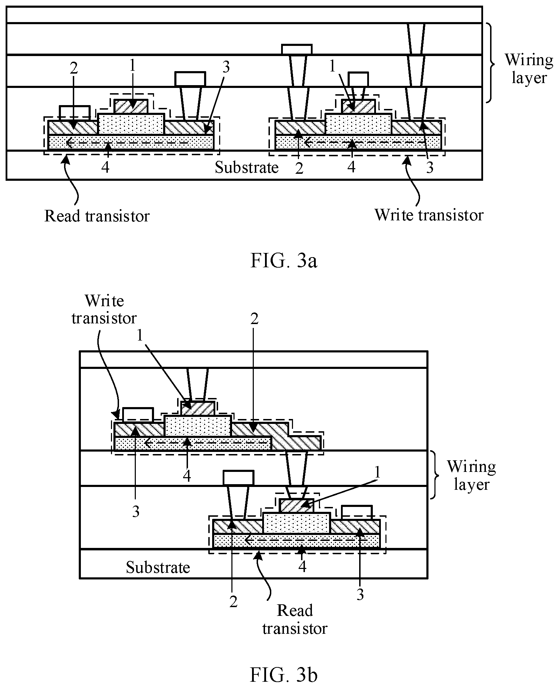

FIG. 3a is a diagram of a structure of a currently prepared 2T0C memory cell shown in FIG. 2. It may be learned from FIG. 3a that both the write transistor and the read transistor are arranged on a substrate, and a gate 1, a source 2, a drain 3, and a semiconductor layer 4 of the write transistor and the read transistor are arranged along a direction parallel to the substrate. The transistor thus formed may be referred to as a "planar" transistor parallel to the substrate, and a channel formed by the semiconductor layer 4 in the "planar" transistor may be referred to as a horizontal channel. Further, a current between the source 2 and the drain 3 (a dotted line with an arrow shown in FIG. 3a) flows along the direction parallel to the substrate. To implement electrical connection between the write transistor and the read transistor, a wiring layer (FIG. 3a shows an approximate position of the wiring layer) that is electrically connected to the write transistor and the read transistor needs to be formed on a side of the write transistor and the read transistor that is away from the substrate. FIG. 3b is a diagram of a structure of another currently prepared 2T0C memory cell. It may be learned from FIG. 3b that the write transistor and the read transistor are arranged on the substrate in a 3-dimensional (3D) stacking manner, and the write transistor is electrically connected to the read transistor through the wiring layer (FIG. 3b shows an approximate position of the wiring layer). Same as in FIG. 3a, either of the write transistor and the read transistor is also the "planar" transistor parallel to the substrate, the channel formed by the semiconductor layer 4 is also the horizontal channel, and the current (dotted line with arrow shown in FIG. 3b) between the source 2 and the drain 3 also flows along the direction parallel to the substrate.

Low area utilization of the memory cell (referring to area utilization on a surface parallel to the substrate) and low integration density exist in both the memory cell of the structure shown in FIG. 3a and the memory cell of the structure shown in FIG. 3b.

With an increasing amount of computing data of a processor, a memory with a higher integration density needs to be designed, to meet people's demand for data processing in the information age.

### SUMMARY

Embodiments of this application provide a forming method for a semiconductor apparatus, an electronic device, and a transistor, and a forming method for a memory, to provide a semiconductor apparatus that can improve an integration density.

To achieve the foregoing objective, the following technical solutions are used in embodiments of this application:
According to a first aspect, this application provides a semiconductor apparatus. The semiconductor apparatus includes a substrate and a first transistor and a second transistor that are formed on the substrate. The second transistor is electrically connected to the first transistor, the first transistor and the second transistor are arranged along a first direction perpendicular to the substrate, and the first transistor and the second transistor each include a gate, a semiconductor layer, a first electrode, and a second electrode; and in either of the first transistor and the second transistor, the gate and the semiconductor layer are arranged along a second direction parallel to the substrate, and the first electrode and the second electrode are disposed on two sides of the semiconductor layer along the first direction and are electrically connected to the semiconductor layer respectively.

In the semiconductor apparatus of the memory provided in embodiments of this application, the first transistor and the second transistor are arranged along the first direction perpendicular to the substrate, to form a 3-dimensional stacking structure. In addition, in each of the first transistor and the second transistor, compared with the conventional technology, the gate and the semiconductor layer are arranged along the second direction parallel to the substrate, rather than along the first direction perpendicular to the substrate. In this way, a transistor structure is formed perpendicular to the substrate, to form a "vertical" transistor. The semiconductor layer in the transistor may be referred to as a vertical channel. In other words, a current between the first electrode and the second electrode flows along the direction perpendicular to the substrate.

Based on the foregoing description, compared with an existing "planar" transistor, for the improved transistor in this application, an area occupied on a surface parallel to the substrate may be reduced, to improve area utilization, and further improve an integration density of the memory cell.

In a possible implementation of the first aspect, either of the first transistor and the second transistor further includes a gate insulation layer, and the gate, the gate insulation layer, and the semiconductor layer are sequentially stacked; and in at least one of the first transistor and the second transistor, a part of a surface of the gate insulation layer away from the gate is covered by the semiconductor layer, and both the first electrode and the second electrode are formed on the gate insulation layer, to form a perpendicular channel.

In a possible implementation of the first aspect, a surface of the first electrode opposite to the second electrode is a first wall surface, a surface of the second electrode opposite to the first electrode is a second wall surface, the first wall surface, the second wall surface, and the surface of the gate insulation layer away from the gate form a concave cavity, and the semiconductor layer is disposed at a position that is of the concave cavity and that is in contact with the surface of the gate insulation layer.

It may also be understood in this way that only a part of a surface of the first electrode that is opposite to the second electrode and that is only close to the gate insulation layer, and a part of a surface of the second electrode that is opposite to the first electrode and that is only close to the gate insulation layer are in contact with the semiconductor layer. In this way, the current between the first electrode and the second electrode may flow between the semiconductor layers perpendicular to the substrate.

In a possible implementation of the first aspect, a surface of the first electrode opposite to the second electrode is a first wall surface, a surface of the second electrode opposite to the first electrode is a second wall surface, the first wall surface, the second wall surface, and the surface of the gate insulation layer away from the gate form a concave cavity, the semiconductor layer is disposed at a position that is of the concave cavity and that is in contact with the surface of the gate insulation layer, and the semiconductor layer is formed at a position that is of the concave cavity and that is in contact with the first wall surface, and at a position that is of the concave cavity and that is in contact with the second wall surface.

In other words, the semiconductor layer not only covers the gate insulation layer, but also covers the surface of the first electrode opposite to the second electrode, and covers the surface of the second electrode opposite to the first electrode. In this way, from the perspective of performance of the formed memory cell, a contact area between the semiconductor layer and the first electrode and the second electrode may be increased, to reduce resistance between the first electrode and the semiconductor layer and between the second electrode and the semiconductor layer, increase a current flow rate, and finally improve a read/write speed of the memory cell; and from the perspective of a process for forming the memory cell, a preparing process flow may be simplified, and process difficulty may be reduced.

In a possible implementation of the first aspect, either of the first transistor and the second transistor further includes a gate insulation layer, and the gate, the gate insulation layer, and the semiconductor layer are sequentially stacked; and in at least one of the first transistor and the second transistor, both the first electrode and the second electrode are formed at the semiconductor layer.

It may be understood that the semiconductor layer covers the gate insulation layer, and the first electrode and the second electrode cover the semiconductor layer. From the perspective of a process for forming the memory cell, a process for forming the semiconductor layer is simple.

In a possible implementation of the first aspect, in at least one of the first transistor and the second transistor, an insulation layer for allowing a current between the first electrode and the semiconductor layer to pass is formed at an interface between the first electrode and the semiconductor layer; and/or an insulation layer for allowing a current between the second electrode and the semiconductor layer to pass is formed at an interface between the second electrode and the semiconductor layer. For example, a thickness of the insulation layer ranges from 0.1 nm to 2 nm. By disposing the insulation layer between the first electrode and the semiconductor layer and between the second electrode and the semiconductor layer, diffusion of metal ions of the first electrode and the second electrode in the semiconductor layer region may be avoided, and a Fermi pinning problem may be avoided.

In a possible implementation of the first aspect, an arrangement direction of the gate and the semiconductor layer in the first transistor is opposite to an arrangement direction of the gate and the semiconductor layer in the second transistor.

Based on the foregoing, the formed first transistor and the formed second transistor are disposed in a reverse direction. Compared with the first transistor and the second transistor that are disposed in a same direction, advantages are as follows: Because the gate of the first transistor is electrically connected to the first electrode of the second transistor, compared with the first transistor and the second transistor that are disposed in a reverse direction, when the first transistor and the second transistor are disposed in a same direction, a physical connection path between the gate of the first transistor and the first electrode of the second transistor needs to be increased (for example, a length of a metal layer needs to be increased). Therefore, when the first transistor and the second transistor are disposed in a reverse direction, first, the physical connection path may be shorten and process difficulty may be reduced, and second, a transmission speed between the first transistor and the second transistor may be improved.

In a possible implementation of the first aspect, a surface of the first electrode and a surface of the second electrode that are away from the gate in the first transistor are flush with a surface of the first electrode and a surface of the second electrode that are close to the gate in the second transistor. In a possible implementation of the first aspect, a surface of the first electrode and a surface of the second electrode that are away from the gate in the first transistor are flush with a surface of the gate away from the first electrode and the second electrode in the second transistor.

In a possible implementation of the first aspect, the first electrode of the second transistor is disposed close to the first transistor; and a metal layer is formed between the first transistor and the second transistor, and the first transistor is electrically connected to the second transistor through the metal layer. The electric connection structure is simple, and is convenient for preparation and implementation.

In a possible implementation of the first aspect, the semiconductor apparatus is a memory, the memory includes a first memory cell, the first memory cell includes the first transistor and the second transistor, and the gate of the first transistor is electrically connected to the first electrode of the second transistor.

In other words, the first transistor and the second transistor that are arranged in the foregoing form are applied to the memory cell of the memory. Compared with an existing memory cell, an area occupied by each memory cell may obviously be reduced. This improves an integration density of the memory cell.

In a possible implementation of the first aspect, the memory further includes a second memory cell, and the first memory cell and the second memory cell are adjacent to each other and are arranged along the second direction; the second memory cell includes a third transistor and a fourth transistor electrically connected to the third transistor; the third transistor and the fourth transistor are arranged along the first direction, and the third transistor and the fourth transistor each include a second gate, a second semiconductor layer, a 2^{nd} first electrode, and a 2^{nd} second electrode; in either of the third transistor and the fourth transistor, the second gate and the second semiconductor layer are arranged along the second direction, and the 2^{nd} first electrode and the 2^{nd} second electrode are disposed on two sides of the second semiconductor layer along the first direction and are electrically connected to the second semiconductor layer respectively; and the first memory cell and the second memory cell are disposed back to back, and the gate of the second transistor is in contact with the second gate of the fourth transistor, to form a common gate.

The first memory cell and the second memory cell share a gate. In this way, an area occupied by each memory cell may be reduced, and a preparing process may be further simplified.

In a possible implementation of the first aspect, the memory further includes: a first signal line, disposed on a side of the first transistor away from the second transistor, where the first signal line is either of a read bit line and a read word line; and a second signal line, disposed on a side of the second transistor away from the first transistor, where both the first signal line and the second signal line extend along the second direction, and the second signal line is a write word line, where in a memory array of the memory, second electrodes of first transistors that are disposed away from second transistors in a plurality of memory cells sequentially arranged along the second direction are electrically connected to a same first signal line; and in the memory array of the memory, gates of second transistors in the plurality of memory cells sequentially arranged along the second direction are electrically connected to a same second signal line.

In other words, a plurality of memory cells arranged along the second direction may share one first signal line (the first signal line is used as either of the read bit line and the read word line), and may also share one second signal line (the second signal line is used as the write word line). In this way, a quantity of first signal lines and a quantity of second signal lines may be reduced, and a structure of the entire memory may be simplified.

In a possible implementation of the first aspect, the memory further includes: a third signal line, where the third signal line is the other of the read bit line and the read word line; and a fourth signal line, where the fourth signal line is a write bit line, both the third signal line and the fourth signal line extend along a third direction, and the second direction is orthogonal to the third direction, where in the memory array of the memory, first electrodes of the first transistors that are disposed close to the second transistors in the plurality of memory cells sequentially arranged along the third direction are electrically connected to a same third signal line; and in the memory array of the memory, second electrodes of the second transistors that are disposed away from the first transistors in the plurality of memory cells sequentially arranged along the third direction are electrically connected to a same fourth signal line.

In other words, a plurality of memory cells arranged along the third direction may share one third signal line (the third signal line is used as the other of the read bit line and the read word line), and may also share one fourth signal line (the fourth signal line is used as the write bit line). Similarly, in this way, a quantity of third signal lines and a quantity of fourth signal lines may be reduced, and a structure of the entire memory may be simplified.

In a possible implementation of the first aspect, the memory includes a first-layer memory array and a second-layer memory array that are adjacent to each other; the first transistors in the plurality of memory cells sequentially arranged along the second direction in the first-layer memory array are close to the first transistors in the plurality of memory cells sequentially arranged along the second direction in the second-layer memory array; and the first signal line in the first-layer memory array and the opposite first signal line in the second-layer memory array are a same signal line.

In a possible implementation of the first aspect, the memory includes a first-layer memory array and a second-layer memory array that are adjacent to each other; the second transistors in the plurality of memory cells sequentially arranged along the second direction in the first-layer memory array are close to the second transistors in the plurality of memory cells sequentially arranged along the second direction in the second-layer memory array; and the second signal line in the first-layer memory array and the opposite second signal line in the second-layer memory array are a same signal line.

In a possible implementation of the first aspect, the memory includes a first-layer memory array and a second-layer memory array that are adjacent to each other; the second transistors in the plurality of memory cells sequentially arranged along the second direction in the first-layer memory array are close to the first transistors in the plurality of memory cells sequentially arranged along the second direction in the second-layer memory array; and the first signal line in the first-layer memory array and the opposite second signal line in the second-layer memory array are a same signal line.

In a possible implementation of the first aspect, the memory includes a first-layer memory array and a second-layer memory array that are adjacent to each other; the second transistors in the plurality of memory cells sequentially arranged along the second direction in the first-layer memory array are close to the first transistors in the plurality of memory cells sequentially arranged along the second direction in the second-layer memory array; and the first signal line in the first-layer memory array and the opposite second signal line in the second-layer memory array are signal lines independent of each other.

According to a second aspect, this application further provides an electronic device, including a circuit board and the semiconductor apparatus according to any implementation of the first aspect, where the circuit board is electrically connected to the semiconductor apparatus.

The electronic device provided in embodiments of this application includes the semiconductor apparatus in the embodiment of the first aspect. Therefore, the electronic device provided in embodiments of this application and the semiconductor apparatus in the foregoing technical solution may resolve a same technical problem and achieve a same expected effect.

In a possible implementation of the second aspect, the electronic device further includes a logic processing circuit, the semiconductor apparatus is a memory, and the logic processing circuit and the memory are integrated in a same chip. In this way, the memory forms an embedded memory. In a possible implementation of the second aspect, the electronic device further includes a logic processing circuit, the semiconductor apparatus is a memory, the logic processing circuit is integrated into a first chip, the memory is integrated into a second chip, the first chip and the second chip are stacked and are electrically connected, and the stacked first chip and second chip are disposed on the circuit board. In this way, the memory forms a stand-alone memory.

In a possible implementation of the second aspect, the electronic device further includes a logic processing circuit, the semiconductor apparatus is a memory, the logic processing circuit is integrated into a first chip, the memory is integrated into a second chip, and the first chip and the second chip are respectively disposed on a circuit board and are electrically connected through the circuit board. In this way, the memory forms a stand-alone memory.

According to a third aspect, this application further provides a forming method for a transistor, and the forming method includes the following steps: sequentially stacking a first conductive layer, a sacrificial layer, and a second conductive layer along a first direction perpendicular to a substrate; providing a first groove that runs through the second conductive layer, the sacrificial layer, and the first conductive layer; sequentially forming a gate insulation layer and a gate on a side wall surface of the first groove along a second direction parallel to the substrate; removing the sacrificial layer in contact with the gate insulation layer, to form a concave cavity, where a first electrode and a second electrode are formed on two sides of the concave cavity; and forming a semiconductor layer on at least a wall surface of the concave cavity close to the gate insulation layer, to form a transistor on the substrate.

According to the forming method for a transistor provided in embodiments of this application, a first groove is provided along the first direction at the first conductive layer, the sacrificial layer, and the second conductive layer that are stacked, the gate insulation layer and the gate are sequentially formed on a side wall surface of the first groove. Then the sacrificial layer in contact with the gate insulation layer is removed, to form the first electrode and the second electrode on two sides of the concave cavity, and then form the semiconductor layer in the concave cavity, to produce a "vertical" transistor perpendicular to the substrate.

In a possible implementation of the third aspect, the forming a semiconductor layer on at least a wall surface of the concave cavity close to the gate insulation layer includes: forming the semiconductor layer on a wall surface of the concave cavity close to the gate insulation layer, on a first wall surface of the first electrode, and on a second wall surface of the second electrode, where the first wall surface is a surface of the first electrode opposite to the second electrode, and the second wall surface is a surface of the second electrode opposite to the first electrode.

In this way, from the perspective of performance of the formed memory cell, a contact area between the semiconductor layer and the first electrode and the second electrode may be increased, to reduce resistance between the first electrode and the semiconductor layer and between the second electrode and the semiconductor layer, increase a current flow rate, and finally improve a read/write speed of the memory cell; and from the perspective of a process for forming the memory cell, a preparing process flow may be simplified, and process difficulty may be reduced.

According to a fourth aspect, this application further provides a forming method for a memory. The forming method includes: forming at least one layer of memory array on a substrate, where the forming method for any layer of memory array includes: forming a plurality of first transistors in array distribution, and forming a plurality of second transistors in array distribution above the plurality of first transistors, where the first transistors and the second transistors are prepared by using the forming method in any implementation of the third aspect; and a gate of the first transistor is electrically connected to a first electrode of the second transistor.

In the memory prepared through the foregoing method, because the first transistor and the second transistor in the prepared memory cell are stacked on the substrate in a 3-dimensional manner, and each transistor is a "vertical" transistor perpendicular to the substrate. The memory thus prepared has a higher integration density of the memory cell compared with the memory prepared in the conventional technology.

In a possible implementation of the fourth aspect, when the first groove is provided, the method includes: providing the plurality of first grooves at intervals along the first direction; when a gate insulation layer and a gate are sequentially formed on a side wall surface of the first groove, the method includes: sequentially forming the gate insulation layer and the gate on two side wall surfaces of any first groove that are opposite to each other; and before removing a sacrificial layer in contact with the gate insulation layer, the method further includes: providing a second groove between two adjacent first grooves.

In a possible implementation of the fourth aspect, when the plurality of second transistors are formed, a providing position of the first groove is directly above the second groove when the plurality of first transistors are formed.

In this way, the second transistors in two adjacent memory cells may share a gate.

In a possible implementation of the fourth aspect, when the first transistor is formed, the method may further include: forming a metal layer on the gate, where the metal layer is in contact with the gate, to cause the gate of the first transistor and the first electrode of the second transistor to be electrically connected through the metal layer.

### BRIEF DESCRIPTION OF DRAWINGS

FIG. 1 is a schematic diagram of a structure of one memory cell in a DRAM;
FIG. 2 is a schematic diagram of a structure of one memory cell in another DRAM;
FIG. 3a is a schematic diagram of a structure of a prepared memory cell shown in FIG. 2 in the conventional technology;
FIG. 3b is another schematic diagram of a structure of the memory cell shown in FIG. 2 prepared in the conventional technology;
FIG. 4 is an exploded schematic diagram of an electronic device according to an embodiment of this application;
FIG. 5 is a schematic diagram of a structure of an electronic device according to an embodiment of this application;
FIG. 6a is a schematic diagram of a partial structure of an electronic device according to an embodiment of this application;
FIG. 6b is a schematic diagram of a partial structure of an electronic device according to an embodiment of this application;
FIG. 6c is a schematic diagram of a partial structure of an electronic device according to an embodiment of this application;
FIG. 7 is a schematic diagram of a structure of an embedded memory according to an embodiment of this application;
FIG. 8 is a schematic diagram of a structure of any layer of memory array according to an embodiment of this application;
FIG. 9 is a schematic diagram of a connection relationship between one memory cell and a WWL, a WBL, an RWL, and an RBL according to an embodiment of this application;
FIG. 10 is a schematic diagram of a structure of a stand-alone memory according to an embodiment of this application;
FIG. 11 is a schematic diagram of a partial structure in FIG. 10;
FIG. 12 is a schematic diagram of a structure of a relative position between a memory cell and a substrate according to an embodiment of this application;
FIG. 13 is a schematic diagram of a structure of another relative position between a memory cell and a substrate according to an embodiment of this application;
FIG. 14 is a schematic diagram of a structure of another relative position between a memory cell and a substrate according to an embodiment of this application;
FIG. 15 is a schematic diagram of a structure of a memory cell according to an embodiment of this application;
FIG. 16 is a schematic diagram of a connection relationship between a first transistor and a second transistor in a memory cell according to an embodiment of this application;
FIG. 17 is a schematic diagram of a structure of a memory cell according to an embodiment of this application;
FIG. 18 is a schematic diagram of a structure of a plurality of memory cells arranged along a second direction X according to an embodiment of this application;
FIG. 19 is an arrangement diagram of some memory cells in a one-layer memory array according to an embodiment of this application;
FIG. 20 is a schematic diagram of a structure of a memory cell according to an embodiment of this application;
FIG. 21 is a 2-dimensional diagram of a structure of a plurality of memory cells arranged along a second direction X according to an embodiment of this application;
FIG. 22 is a 3-dimensional diagram of a structure of a plurality of memory cells arranged along a second direction X according to an embodiment of this application;
FIG. 23 is a 3-dimensional diagram of a structure of a plurality of memory cells arranged along a third direction Y according to an embodiment of this application;
FIG. 24 is a schematic diagram of a structure of a memory in two layers of memory arrays according to an embodiment of this application;
FIG. 25 is a view of an M direction in FIG. 24;
FIG. 26 is a schematic diagram of a structure of a memory in three layers of memory arrays according to an embodiment of this application;
FIG. 27 is a schematic diagram of a structure of a memory in two layers of memory arrays according to an embodiment of this application;
FIG. 28 is a schematic diagram of a structure of a memory in two layers of memory arrays according to an embodiment of this application;
FIG. 29 is a process flowchart of a forming method for a plurality of transistors in a memory cell in a memory according to an embodiment of this application;
FIG. 30(a) to FIG. 30(f) are a schematic diagram of a structure of each step of performing the process flow in FIG. 29;
FIG. 31 is a process flowchart of a forming method for a memory according to an embodiment of this application; and
FIG. 32(a) to FIG. 32(r) are a schematic diagram of a structure of performing each step when a memory is formed according to an embodiment of this application.

### Reference numerals:

11-Middle frame; 110-bearing plate; 111-frame; 12-rear housing; 13-display screen; 01-PCB; 02-chip; 021-first chip; 022-second chip; 100-substrate; 200-memory cell; 201-first memory cell; 202-second memory cell; 301-first transistor; 302-second transistor; 1-gate; 2-first electrode; 3-second electrode; 4-semiconductor layer; 5-gate insulation layer; 6-metal layer; 7-insulation layer; 8-concave cavity; 91-first signal line; 92-second signal line; 93-third signal line; 94-fourth signal line; 21-first conductive layer; 22-sacrificial layer; 23-second conductive layer; 24-first insulation layer; 251, 2511, 2512-first groove; 252, 2521, 2522-second groove; 26-patterned layer; 261-metal connection layer; and 262, 2621, 2622, 2623-second insulation layer.

### DESCRIPTION OF EMBODIMENTS

Embodiments of this application provide an electronic device. The electronic device may include a mobile phone (mobile phone), a tablet computer (pad), a smart wearable product (for example, a smart watch or a smart band), a virtual reality (virtual reality, VR) device, or an augmented reality (augmented reality, AR) device, or may be a household appliance, or may be a device such as an automobile or an artificial intelligence device, or may be a server (server), a data center (data center), or the like. A specific form of the electronic device is not specially limited in embodiments of this application.

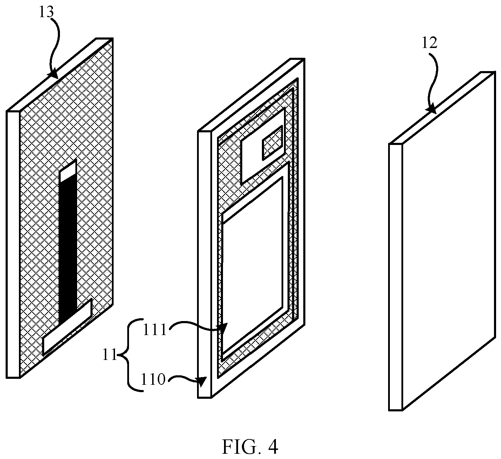

A mobile phone is used as an example for any one of the foregoing electronic devices. As shown in FIG. 4, the electronic device 01 may include a middle frame 11, a rear housing 12, and a display screen 13. The middle frame 11 includes a bearing plate 110 configured to bear the display screen 13, and a frame 111 surrounding the bearing plate 110. The rear housing 12 is connected to the middle frame 11, to prevent external moisture and dust from affecting performance of a structure (for example, to prevent a circuit board carried on the bearing plate 110 and an electronic component carried on the circuit board) in the electronic device.

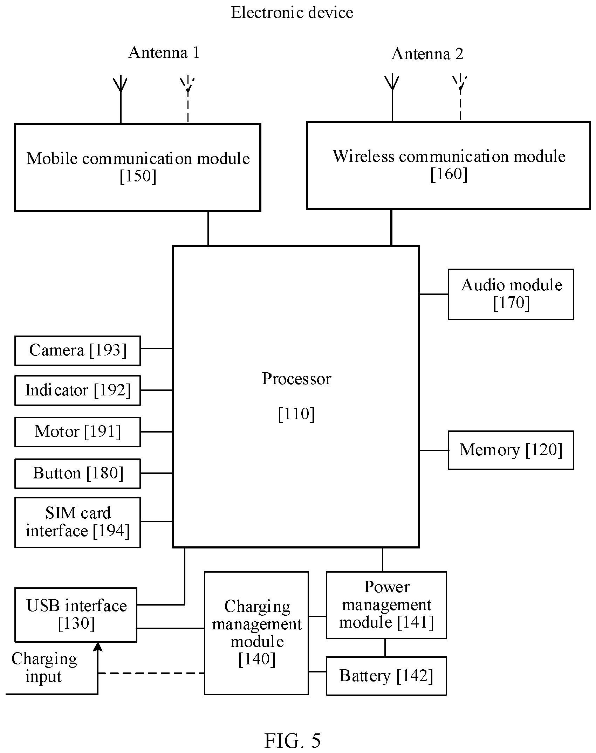

With reference to FIG. 5, the electronic device may further include a processor 110, a memory 120, a universal serial bus (universal serial bus, USB) interface 130, a charging management module 140, a power management module 141, a battery 142, an antenna 1, an antenna 2, a mobile communication module 150, and a wireless communication module 160, an audio module 170, a button 180, a motor 191, an indicator 192, a camera 193, a subscriber identification module (subscriber identification module, SIM) card interface 194, and the like.

It may be understood that the structure shown in FIG. 5 does not constitute a specific limitation on the electronic device. In some other embodiments of this application, the electronic device may include more or fewer components than those shown in FIG. 5, or some components may be combined, or some components may be split, or different component arrangements may be used. The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identification module (subscriber identification module, SIM) interface 194, a universal serial bus (universal serial bus, USB) port 130, and/or the like.

The USB interface 130 may be specifically a mini USB interface, a micro USB interface, a USB type-C interface, or the like. The USB interface 130 may be configured to connect to the charger to charge the electronic device, or may be used for data transmission between the electronic device and a peripheral device. Alternatively, the USB interface may be configured to connect to a headset for playing audio through the headset.

The SIM card interface 194 is configured to connect to a SIM card. The SIM card may be inserted into the SIM card interface 194 or unplugged from the SIM card interface 194, to come into contact with or be separated from the electronic device. The electronic device may support one or N SIM card interfaces, and N is a positive integer greater than 1.

It may be understood that an interface connection relationship between the modules illustrated in embodiments of the present invention is merely an example for description, and does not constitute a limitation on a structure of the electronic device. In some other embodiments of this application, the electronic device may alternatively use an interface connection manner different from that in the foregoing embodiment, or use a combination of a plurality of interface connection manners. The charging management module 140 is configured to receive a charging input from a charger. The charger may be a wireless charger or a wired charger.

The power management module 141 is configured to connect to the battery 142, the charging management module 140, and the processor 110. The power management module 141 receives an input from the battery 142 and/or the charging management module 140, and supplies power to the processor 110, the memory 120, the camera 1930, and the like. The power management module 141 may be further configured to monitor parameters such as a battery capacity, a battery cycle count, and a battery health status (electric leakage or impedance). In some other embodiments, the power management module 141 may alternatively be disposed in the processor 110. In some other embodiments, the power management module 141 and the charging management module 140 may alternatively be disposed in a same device.

A wireless communication function of the electronic device may be implemented by using the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna of the electronic device may be configured to cover one or more communication frequency bands. Different antennas may also be multiplexed to improve utilization of the antennas. For example, an antenna 1 may be multiplexed as a diversity antenna of a wireless local area network. In some other embodiments, the antennas may be used in combination with a tuning switch.

The mobile communication module 150 may provide a solution to wireless communication such as 2G/3G/4G/5G applicable to the electronic device. The mobile communication module 150 may include at least one filter, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1.

The wireless communication module 160 may provide a solution to wireless communication applicable to the electronic device, for example, a wireless local area network (wireless local area networks, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), near field communication (near field communication, NFC), and an infrared (infrared, IR) technology. The wireless communication module 160 may be one or more components into which at least one communication processing module is integrated. The wireless communication module 160 receives an electromagnetic wave through the antenna 2, performs frequency modulation and filtering processing on an electromagnetic wave signal, and sends a processed signal to the processor 110. The wireless communication module 160 may alternatively receive a to-be-sent signal from the processor 110, perform frequency modulation and amplification on the to-be-sent signal, and convert the signal into an electromagnetic wave for radiation by using the antenna 2.

In some embodiments, the antenna 1 of the electronic device is electrically connected to the mobile communication module 150, and the antenna 2 is electrically connected to the wireless communication module 160, so that the electronic device may communicate with a network and another device through a wireless communication technology. The wireless communication technology may include a global system for mobile communications (global system for mobile communications, GSM), a general packet radio service (general packet radio service, GPRS), code division multiple access (code division multiple access, CDMA) and the like.

The camera 193 is configured to capture a static image or a video. In some embodiments, the electronic device may include one or N cameras 193, where N is a positive integer greater than 1. The memory 120 may be configured to store computer-executable program code. The executable program code includes instructions. The processor 110 runs the instructions stored in the memory 120, and/or the instructions stored in the memory arranged in the processor to perform various function applications and data processing of the electronic device.

The electronic device may implement an audio function through an audio module 170, an application processor, or the like, for example, implement a music playback function and a recording function.

The audio module 170 is configured to convert digital audio information into an analog audio signal output, and is further configured to convert an analog audio input into a digital audio signal. The audio module 170 may be further configured to code and decode an audio signal.

The button 180 includes a power button, a volume button, and the like. The button 180 may be a mechanical button, or may be a touch button. The electronic device may receive a key input, and generate a key signal input related to user setting and function control of the electronic device. The motor 191 may generate a vibration prompt. The motor 191 may be configured to provide an incoming call vibration prompt and a touch vibration feedback.

The indicator 192 may be an indicator light, and may be configured to indicate a charging status and a power change, or may be configured to indicate a message, a missed call, a notification, and the like.

Based on this, the electronic device 100 may further include a circuit board, for example, a printed circuit board (printed circuit board, PCB). The processor 110, the memory 120, and the like may be disposed on the circuit board, and the processor 110, the memory 120, and the like are electrically connected to the circuit board.

The following separately describes the memory in different forms in the electronic device with reference to the accompanying drawings.

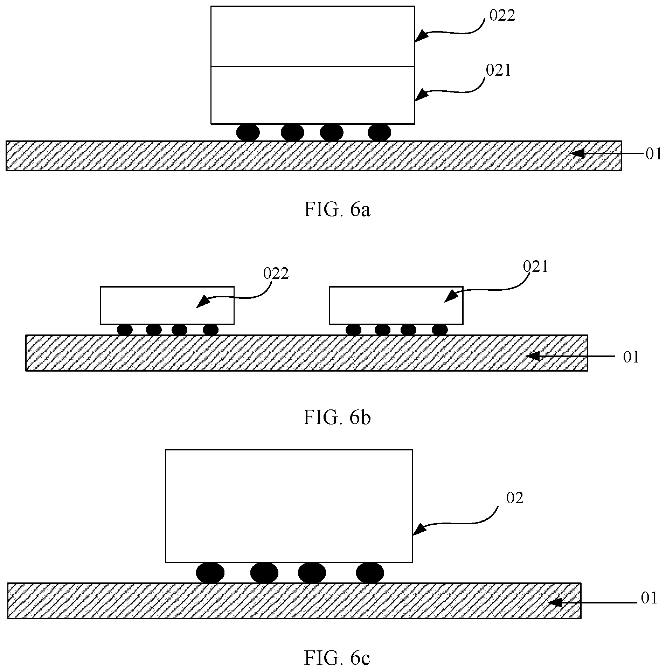

FIG. 6a shows a form of a memory. A first chip 021 and a second chip 022 are stacked on a PCB 01. One of the first chip 021 and the second chip 022 is a processor, and the other of the first chip 021 and the second chip 022 is a memory, for example, a DRAM. In addition, the first chip 021 and the second chip 022 may be connected through a through silicon via (through silicon via, TSV) and a redistribution layer (redistribution layer, RDL). In FIG. 6a, because the processor and the memory are two independent chips, the memory may be referred to as a stand-alone memory.

FIG. 6b shows another form of the memory. The first chip 021 and the second chip 022 may be separately connected to the PCB 01 through an electrical connection structure, for example, connected to the PCB 01 through a ball grid array (ball grid array, BGA). One of the first chip 021 and the second chip 022 is the processor, and the other of the first chip 021 and the second chip 022 is the memory. The processor and the memory may be electrically connected through metal wiring arranged on the PCB 01. As in FIG. 6a, because the processor and the memory are two independent chips, the memory may be referred to as a stand-alone memory.

FIG. 6c shows yet another form of the memory. The memory and the processor are integrated into a same chip 02. Therefore, the memory may be referred to as an embedded memory.

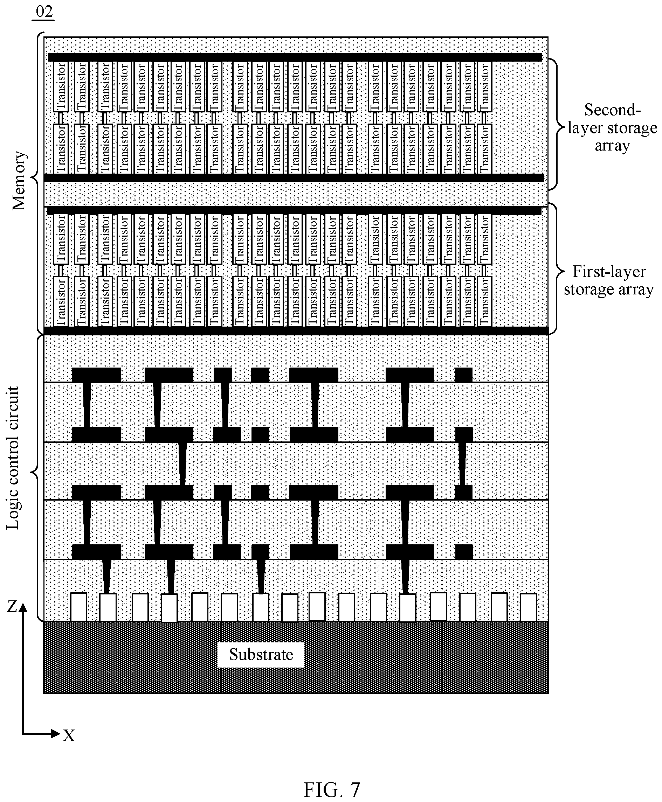

The foregoing memory may be a DRAM including a 2T0C memory cell. FIG. 7 shows a DRAM including a 2T0C memory cell. The DRAM is an embedded DRAM. For example, a logic control circuit (which may also be referred to as a processor) is integrated on a substrate of a chip 02. The DRAM is integrated on the logic control circuit through a back end of line (BEOL) process. The logic control circuit may generate control signals. These control signals may be read/write control signals, and are used to control a read/write operation of data in the memory.

FIG. 7 shows two layers of memory arrays in the DRAM, which are respectively a first-layer memory array and a second-layer memory array. In some optional implementations, the DRAM may include only one layer of memory array or more layers of memory arrays. When including two or more layers of memory arrays, the DRAM may also be referred to as a 3-dimensional integrated DRAM.

A quantity of layers of the memory array may be stacked as required. A greater quantity of layers of the stacked memory array indicates a higher storage density of the memory.

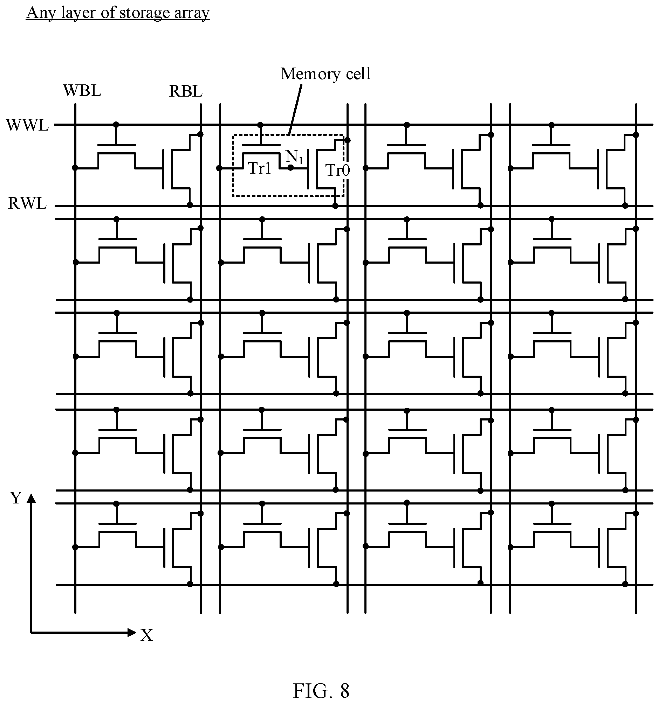

FIG. 8 is a schematic diagram of a structure of any layer of memory array in FIG. 7. Each layer of memory array includes a plurality of memory cells in array distribution, a write word line (write word line, WWL), a write bit line (write bit line, WBL), a read word line (read word line, RWL), and a read bit line (read bit line, RBL).

Still with reference to FIG. 8, any memory cell includes two transistors, one of the two transistors may be referred to as a write transistor Tr1, the other of the two transistors may be referred to as a read transistor Tr0, and the write transistor Tr1 and the read transistor Tr0 are three-terminal components having a source, a drain, and a gate.

In this field, the source in the transistor may also be referred to as a source terminal, and the drain in the transistor may also be referred to as a drain terminal. Similarly, the gate in the transistor may also be referred to as a gate terminal.

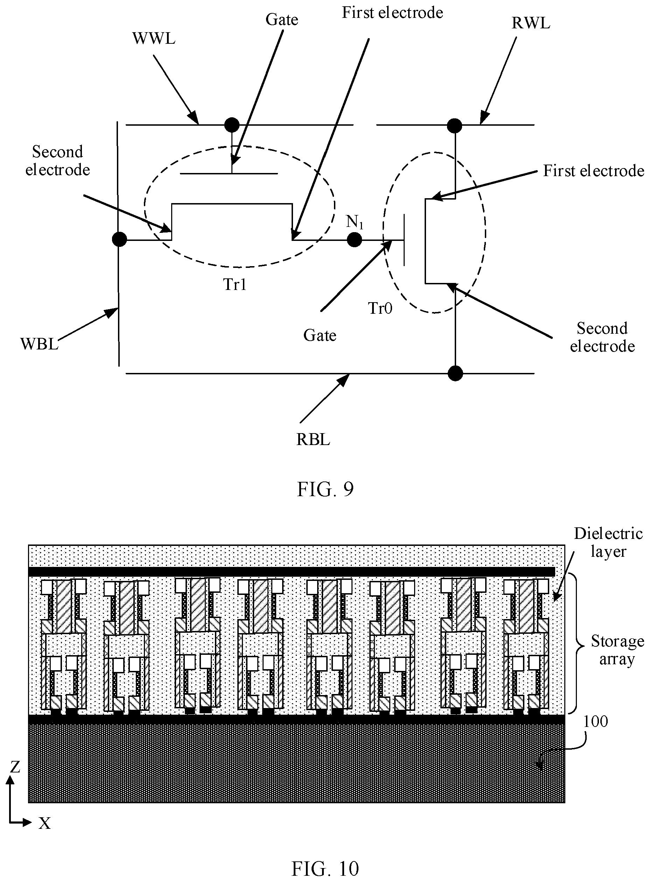

FIG. 9 is a diagram of a connection structure between one of the memory cells in FIG. 8 and a WWL, a WBL, an RWL, and an RBL. A first electrode of a write transistor Tr1 is electrically connected to a gate of a read transistor Tr0, a second electrode of the write transistor Tr1 is electrically connected to the WBL, a gate of the write transistor Tr1 is electrically connected to the WWL, a first electrode of the read transistor Tr0 is electrically connected to the RWL, and a second electrode of the read transistor Tr0 is electrically connected to the RBL.

It should be noted that the first electrode involved in this application refers to one of a source and a drain in a transistor, and the second electrode refers to the other of the source and the drain in the transistor.

Still referring to FIG. 9, a write operation process and a read operation process of the 2T0C memory cell are separately described.

The write operation process: In the write operation process, a voltage of the RWL and a voltage of the RBL are 0, and the read transistor Tr0 does not operate; and the WWL provides a first switch signal, and the first switch signal controls the write transistor Tr1 to be connected. When first logic information is written, for example, "0", the WBL provides a first level signal, and the first level signal is written to a node N through the write transistor Tr1. When second logic information is written, for example, "1", the WBL provides a second level signal, and the second level signal is written to the node N through the write transistor Tr1.

It should be understood that after the write operation is completed, the voltage of the RWL and the voltage of the RBL are 0, and the read transistor Tr0 does not operate; and the WWL provides a second switch signal, and the second switch signal controls the write transistor Tr1 to be disconnected. In this case, a potential stored in the node N is not affected by the outside.

The read operation process: The WWL provides the second switch signal, and the second switch signal controls the write transistor Tr1 to be disconnected. The RWL provides a third level signal to determine stored logic information of a memory cell based on a current on the RBL. When the node N stores the first level signal, because the first level signal may control the read transistor Tr0 to be connected, when the RWL provides the third level signal, the RWL charges the RBL through the read transistor Tr0, and the voltage on the RBL increases. In this way, when it is detected that the current on the RBL is high, it may be read that the memory cell stores logic information "0". When the node N stores the second level signal, because the second level signal may control the read transistor Tr0 to be disconnected, when the RWL provides the third level signal, the RWL does not charge the RBL through the read transistor Tr0, and the RBL maintains a voltage of 0 V. In this way, when it is detected that the current on the RBL is low, it may be read that the memory cell stores logic information "1".

At least one of the write transistor Tr1 and the read transistor Tr0 in FIG. 9 may be a thin film transistor (thin film transistor, TFT), for example, an oxide-semiconductor thin-film transistor (oxide-semiconductor thin-film transistor, OSTFT).

When the OSTFT is used as the write transistor and the read transistor, because the OSTFT has an advantage of ultra-low current leakage, storage duration of the memory cell may be greatly improved, and dynamic power consumption may be reduced. In addition, the OSTFT also has an advantage of low process temperature. In this way, a memory cell having the OSTFT may use a BEOL process, to implement 3D system integration. This may reduce an occupied area of a memory cell array. If the memory cell is applied to an embedded DRAM, more space may be reserved for a computational logic circuit.

To further reduce space occupied by the 2T0C memory cell and implement high-density storage application, embodiments of this application further provide another memory including the 2T0C memory cell. The following describes the memory in detail with reference to the accompanying drawings.

FIG. 10 is a diagram of a structure of a memory according to this application. The memory includes a substrate 100 and at least one layer of memory array disposed on the substrate 100. FIG. 10 shows an example that only one layer of memory array is included. When two or more layers of memory arrays are included, the multi-layer memory arrays are sequentially arranged along a first direction Z shown in FIG. 10.

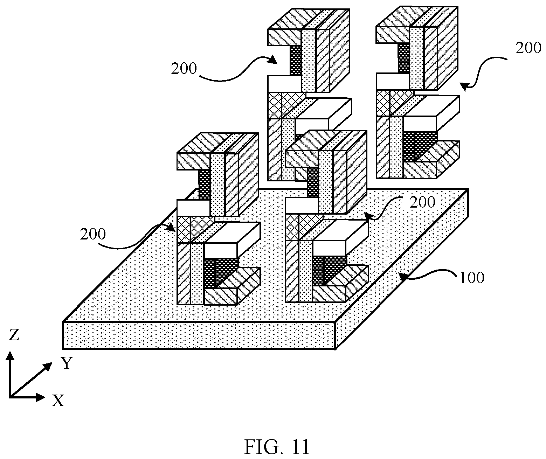

Each layer of memory array includes a plurality of memory cells arranged in an array. FIG. 11 shows an example of four memory cells 200 of one layer of memory array. These memory cells 200 are arranged in an array in a plane in which a second direction X and a third direction Y are located. The second direction X is intersected with the third direction Y, for example, orthogonal, and a first direction Z is orthogonal to the second direction X and the third direction Y.

The following describes the 2T0C memory cell in embodiments of this application with reference to the accompanying drawings.

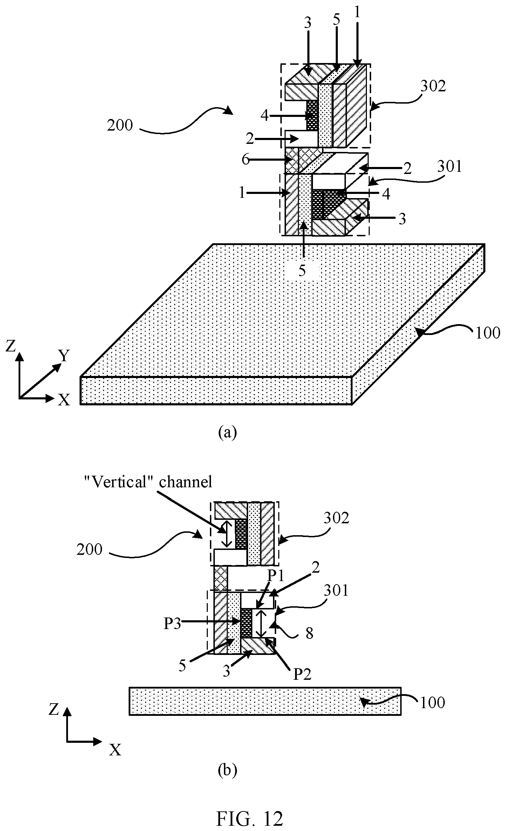

(a) in FIG. 12 shows a 3-dimensional diagram of a structure of a relative position between one memory cell 200 and a substrate 100. (b) in FIG. 12 shows a 2-dimensional diagram of a structure in (a) in FIG. 12. The memory cell 200 includes a first transistor 301 and a second transistor 302. At least one of the first transistor 301 and the second transistor 302 may use a TFT. The first transistor 301 and the second transistor 302 are arranged along a first direction Z perpendicular to the substrate 100.

As shown in FIG. 12, either of the first transistor 301 and the second transistor 302 may include: a gate 1, a first electrode 2, a second electrode 3, a semiconductor layer 4, and a gate insulation layer 5.

Materials of the gate 1, the first electrode 2, and the second electrode 3 are all conductive materials, for example, a metal material. Specifically, the materials of the gate 1, the first electrode 2, and the second electrode 3 may be one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver).

A material of the semiconductor layer 4 may be one or more of semiconductor materials such as Si (silicon), poly-Si (p-Si, polysilicon), amorphous-Si (a-Si, amorphous silicon), In-Ga-Zn-O (IGZO, indium gallium zinc oxide) polycompound, ZnO (zinc oxide), ITO (indium tin oxide), TiO₂ (titanium dioxide), MoS₂ (molybdenum disulfide), WS₂ (tungsten disulfide). The semiconductor layer 4 may also be referred to as a channel layer.

A material of the gate insulation layer 5 may be one or more of insulating materials such as SiO₂ (silica), Al₂O₃ (alumina), HfO₂ (hafnium dioxide), ZrO₂ (zirconia), TiO₂ (titanium dioxide), Y₂O₃ (yttrium trioxide), and Si₃N₄ (silicon nitride). The gate insulation layer 5 is used to isolate the gate 1 from the semiconductor layer 4, and the gate insulation layer 5 may also be referred to as a gate dielectric layer or a gate oxide dielectric layer.

Still with reference to FIG. 12, the gate 1, the gate insulation layer 5, and the semiconductor layer 4 are arranged in a stacking manner along the second direction X parallel to the substrate 100, and the first electrode 2 and the second electrode 3 are arranged on two sides of the semiconductor layer 4 along the first direction Z. The first electrode 2 forms an ohmic contact with and is electrically connected to the semiconductor layer 4, and the second electrode 108 forms an ohmic contact with and is electrically connected to the semiconductor layer 102. In this way, the transistor thus formed may be referred to as a "vertical" transistor perpendicular to the substrate 100, and a channel between the first electrode 2 and the second electrode 3 is a "vertical" channel relative to the substrate 100. As shown in (b) in FIG. 12, a black line with double arrows represents that the channel is a "vertical" channel perpendicular to the substrate 100.

Compared with the existing "planar" transistor arranged in parallel to the substrate 100, a "vertical" transistor is used in this application, and two "vertical" transistors are stacked in a 3D manner along the first direction Z, so that a quantity of integrated memory cells may be increased, and a degree of integration of the memory cells may be improved. For example, a greater quantity of memory cells may be integrated per unit area. This increases a memory capacity.

In FIG. 12, the gate 1 of the first transistor 301 is electrically connected to the first electrode 2 disposed close to the first transistor 301 of the second transistor 302. Further, the first transistor 301 is referred to as a read transistor, and the second transistor 302 is referred to as a write transistor. In FIG. 12, the read transistor is disposed close to the substrate 100 relative to the write transistor. Certainly, in some other implementations, the write transistor may be disposed close to the substrate 100 relative to the read transistor.

The semiconductor layer 4 of this application has a plurality of arrangement manners, and different arrangement manners of the semiconductor layer 4 will be described below.

FIG. 12 provides an arrangement manner of the semiconductor layer 4. A part of a surface of the gate insulation layer 5 away from the gate 1 is covered by the semiconductor layer 4, and both the first electrode 2 and the second electrode 3 are formed on the gate insulation layer 5.

In (b) in FIG. 12, a surface of the first electrode 2 opposite to the second electrode 3 may be referred to as a first wall surface P1, a surface of the second electrode 3 opposite to the first electrode 2 may be referred to as a second wall surface P2, and a surface of the gate insulation layer 5 away from the gate 1 is referred to as a third wall surface P3. It may be learned from (b) in FIG. 12 that the second wall surface P1, the second wall surface P2, and the third wall surface P3 enclose a concave cavity 8. The semiconductor layer 4 is disposed at a position that is of the concave cavity 8 and that is in contact with the third wall surface P3.

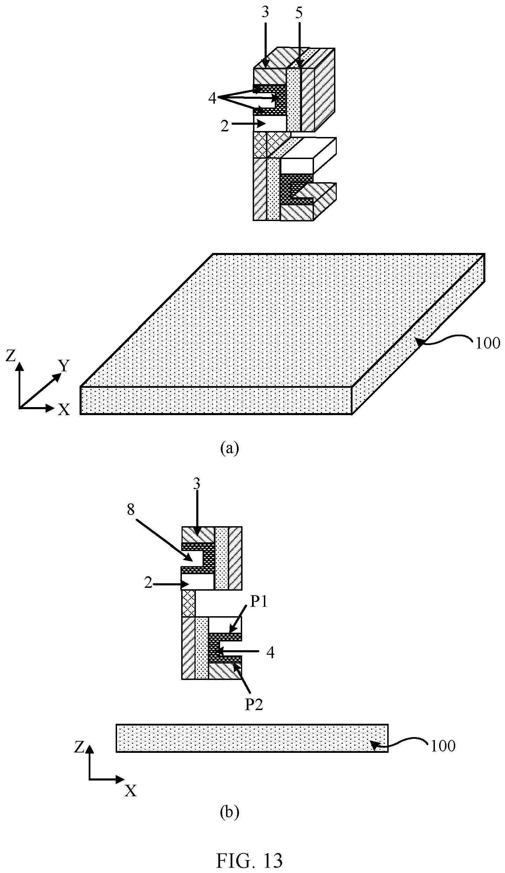

FIG. 13 provides another arrangement manner of a semiconductor layer 4, except that the semiconductor layer 4 is disposed at a position that is of a concave cavity 8 and that is in contact with a third wall surface P3 in the same manner as the structure shown in FIG. 12. The semiconductor layer 4 is disposed at a position that is of the concave cavity 8 and that is in contact with a first wall surface P1, and the semiconductor layer 4 is also disposed at a position that is of the concave cavity 8 and that is in contact with a second wall surface P2.

In terms of performance of a transistor that forms the structure, because the semiconductor layer 4 shown in FIG. 13 covers not only a gate insulation layer 5, but also a surface of a first electrode 2 opposite to a second electrode 3, and a surface of the second electrode 3 opposite to the first electrode 2. In this way, an ohmic contact area between the semiconductor layer 4 and the first electrode 2 and an ohmic contact area between the semiconductor layer and the second electrode 3 may be increased, and resistance between the semiconductor layer 4 and the first electrode 2 and resistance between the semiconductor layer 4 and the second electrode 3 may be reduced, to increase a current flow rate, and ultimately improve a read/write speed of the memory cell. From the perspective of a process for forming a transistor with the structure, when the transistor is formed, as shown in FIG. 13, a concave cavity 8 needs to be first formed between the first electrode 2 and the second electrode 3, and then, the semiconductor layer 4 is deposited on a wall surface of the concave cavity 8 by using physical vapor deposition (physical vapor deposition, PVD) or chemical vapor deposition (CVD). To form the semiconductor layer shown in FIG. 13, compared with the semiconductor layer structure shown in FIG. 12, the semiconductor layer 4 on the surface of the first electrode 2 opposite to the second electrode 3 does not need to be removed, and the semiconductor layer 4 on the surface of the second electrode 3 opposite to the first electrode 2 does not need to be removed. In this way, a preparing process may be simplified and process difficulty may be reduced.

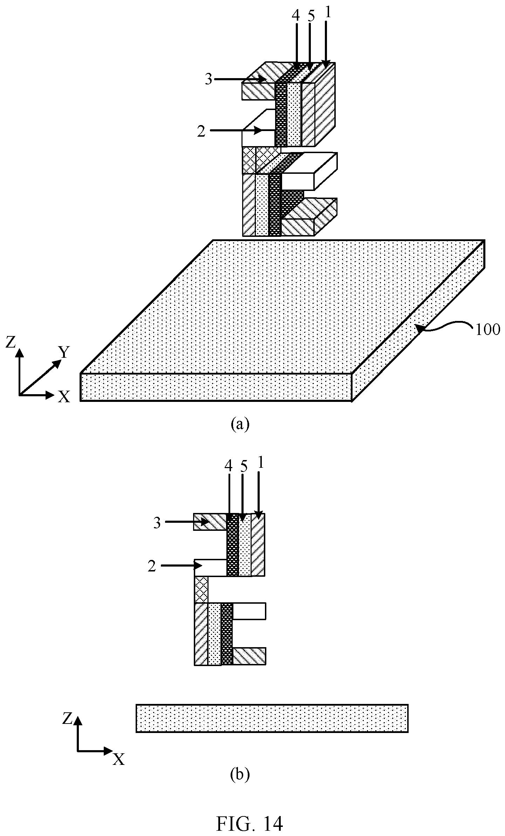

FIG. 14 provides yet another arrangement manner of a semiconductor layer 4. The semiconductor layer 4 is covered on a gate insulation layer 5, and both a first electrode 2 and a second electrode 3 are formed at the semiconductor layer 4.

From the perspective of a process for forming a transistor with the structure, when the transistor is formed, as shown in FIG. 14, the semiconductor layer 4, the gate insulation layer 5, and a gate 1 are sequentially stacked on side surfaces of the first electrode 2 and the second electrode 3, so that the forming process is simple, and is convenient for preparation and implementation.

In some implementations, for example, when the semiconductor layer 4 shown in FIG. 12, FIG. 13, or FIG. 14 is in direct contact with the first electrode 2 and the second electrode 3, in a region in which the first electrode 2 is in contact with the semiconductor layer 4, or in a region in which the second electrode 3 is in contact with the semiconductor layer 4, it is possible that conductive ions in the first electrode 2 and the second electrode 3 diffuse into the semiconductor layer 4, or that there is a phenomenon of a Fermi pinning effect (pinning effect).

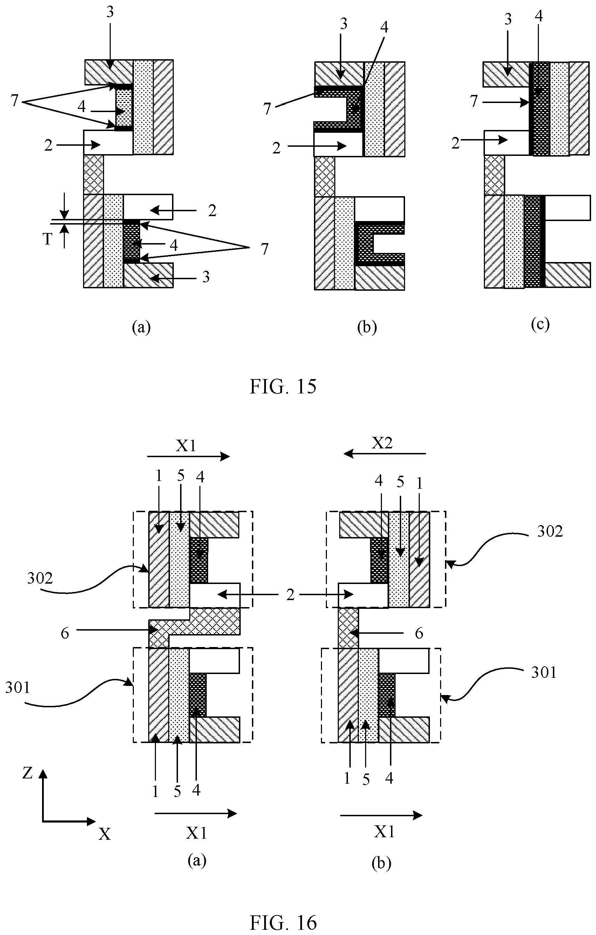

To avoid the conductive ions in the first electrode 2 and the second electrode 3 from diffusing into the semiconductor layer 4, or Fermi pinning, thereby reducing performance of the transistor, for example, a reading speed, with reference to FIG. 15, an insulation layer 7 may be formed at an interface on which the first electrode 2 is in contact with the semiconductor layer 4, or an insulation layer 7 is formed at an interface on which the second electrode 3 is in contact with the semiconductor layer 4, or an insulation layer 7 is formed both at an interface on which the first electrode 2 is in contact with the semiconductor layer 4 and at an interface on which the second electrode 3 is in contact with the semiconductor layer 4.

To ensure that a current between the first electrode 2 and the semiconductor layer 4 and a current between the second electrode 3 and the semiconductor layer 4 pass smoothly, a thickness of the insulation layer 7 needs to be limited, so that the insulation layer 7 cannot prevent the current from passing through. For example, the thickness of the insulation layer 7 may be selected to range from 0.1 nanometers to 2 nanometers. Certainly, the thickness of the insulation layer 7 may also be selected to be in another range, provided that it can be ensured that the current can flow through an insulation layer between the first electrode, the second electrode, and the semiconductor layer. A material of the insulation layer 7 may be one or more of insulating materials such as SiO₂ (silica), Al₂O₃ (alumina), HfO₂ (hafnium dioxide), ZrO₂ (zirconia), TiO₂ (titanium dioxide), Y₂O₃ (yttrium trioxide), and Si₃N₄ (silicon nitride). The material of the insulation layer 7 may be the same as or different from the material of the gate insulation layer 5. (a) in FIG. 15 shows that an insulation layer 7 is added based on the memory cell shown in FIG.12. (b) in FIG. 15 shows that an insulation layer 7 is added based on the memory cell shown in FIG. 13. (c) in FIG. 15 shows that an insulation layer 7 is added based on the memory cell shown in FIG. 14.

In the memory provided in embodiments of this application, an arrangement direction of a first transistor 301 and a second transistor 302 in each memory cell may be shown in FIG. 16.

In (a) in FIG. 16, a gate 1, a gate insulation layer 5, and a semiconductor layer 4 of the first transistor 301 are stacked along an X1 direction, and a gate 1, a gate insulation layer 5, and a semiconductor layer 4 of the second transistor 302 are also stacked along the X1 direction.

In (b) in FIG. 16, the gate 1, the gate insulation layer 5, and the semiconductor layer 4 of the first transistor 301 are stacked along the X1 direction, but the gate 1, the gate insulation layer 5, and the semiconductor layer 4 of the second transistor 302 are stacked along the X2 direction. The X2 direction is opposite to the X1 direction. The memory cell shown in (b) in FIG. 16 may be referred to as a 2T reversely disposed memory cell. To be specific, a memory cell in which two transistors are reversely disposed.

Still with reference to (a) and (b) in FIG. 16, the gate 1 of the first transistor 301 is electrically connected to a first electrode 2 of the second transistor 302 through a metal layer 6. When (b) is compared with (a), it may be obviously learned that a length of the metal layer 6 in (b) is obviously shorter than a length of the metal layer 6 in (a). In this way, in terms of a forming process, a preparing process in (b) is simpler than a preparing process in (a). In terms of performance of the memory cell, a transfer speed in a current transfer path segment in (b) is faster than a transfer speed in a current transfer path segment in (a), so that a read/write speed of the memory cell is faster. A material of the metal layer 6 is a conductive material. In some implementations, the material of the metal layer 6 may be the same as a material of the gate 1 of the first transistor 301 and a material of the first electrode 2 of the second transistor 302. For example, one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver) may be selected.

In some optional implementations, as shown in (a) and (b) in FIG. 16, a surface of the metal layer 6 that faces the first transistor 301 is in contact with the gate 1 of the first transistor 301, and a surface of the metal layer 6 that faces the second transistor 302 is in contact with the first electrode 2 of the second transistor 302, so that the gate 1 of the first transistor 301 is electrically connected to the first electrode 2 of the second transistor 302 through the metal layer 6.

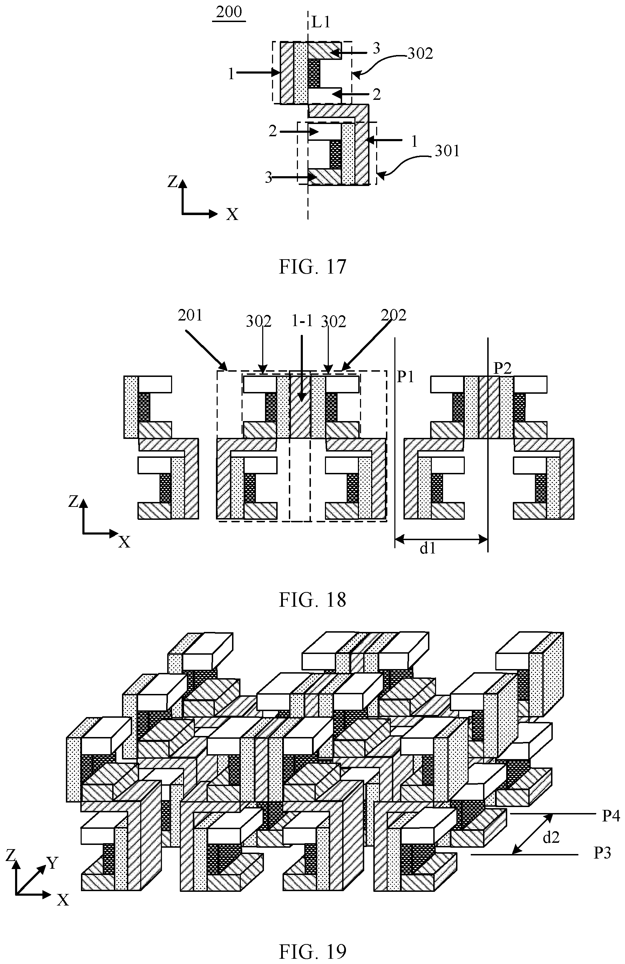

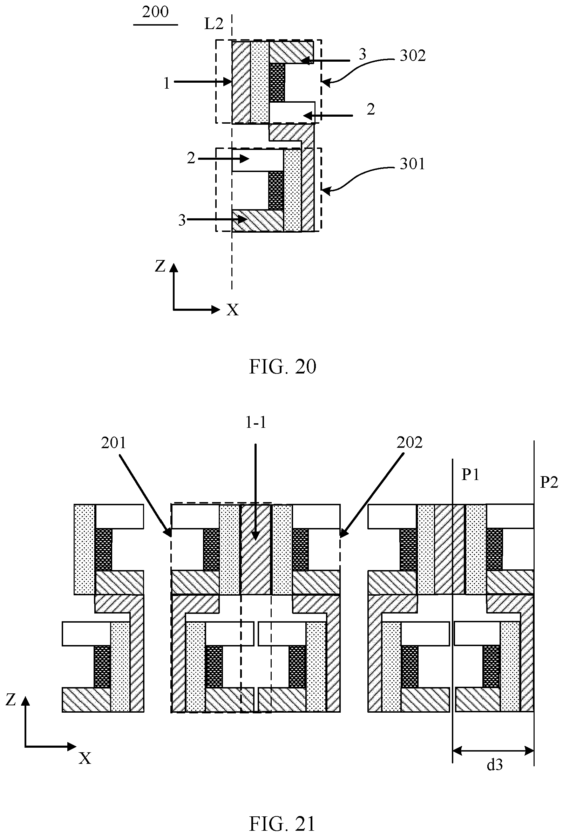

When the 2T shown in (b) in FIG. 16 is used to reversely dispose the memory cell, there are also a plurality of arrangement manners of a relative position between the first transistor 301 and the second transistor 302, for example, as shown in FIG. 17 and FIG. 20.

FIG. 17 shows a relative position between a first transistor 301 and a second transistor 302. In a memory cell 200 shown in FIG. 17, a surface of a first electrode 2 and a surface of a second electrode 3 of the first transistor 301 that are away from a gate 1 are flush with a surface of a first electrode 2 and a surface of a second electrode 3 that are close to a gate 1 in the second transistor 302 (as shown in a dashed line L1 in FIG. 17).

FIG. 18 shows a plurality of memory cells sequentially arranged along a second direction X in a memory array. FIG. 19 shows some memory cells of one layer of memory array. Each memory cell in FIG. 18 and FIG. 19 uses the memory cell structure shown in FIG. 17.

The structure shown in FIG. 18 includes a first memory cell 201 and a second memory cell 202 that are adjacent to each other. The first memory cell 201 and the second memory cell 202 are disposed back to back, and a gate of a second transistor 302 in the first memory cell 201 and a gate of a second transistor 302 in the second memory cell 202 are one gate, to form a common gate 1-1. In this way, compared with forming a gate for a second transistor of each memory cell, a preparing process may be simplified.

It may be learned from FIG. 18 that a distance occupied by each memory cell along a second direction X is d1. In addition, it may be learned from FIG. 19 that a distance occupied by each memory cell along a third direction Y is d2. In this way, an area occupied by each memory cell is S=d1×d2.

FIG. 20 shows another relative position between a first transistor 301 and a second transistor 302. In a memory cell 200 shown in FIG. 20, a surface of a first electrode 2 and a surface of a second electrode 3 that are away from a gate 1 in the first transistor 301 are flush with a surface of a first electrode 2 and a surface of a second electrode 3 that are away from a gate 1 in the second transistor 302 (as shown in a dashed line L2 in FIG. 20).

FIG. 21 shows a plurality of memory cells sequentially arranged along a second direction X in a memory array. The structure shown in FIG. 21 also includes a first memory cell 201 and a second memory cell 202 that are adjacent to each other. The first memory cell 201 and the second memory cell 202 are disposed back to back. A structure that is the same as the structure shown in FIG. 18 is that a gate of a second transistor 302 in the first memory cell 201 and a gate of a second transistor 302 in the second memory cell 202 are one gate, to form a common gate 1-1.

It may be learned from FIG. 21 that a distance occupied by each memory cell along the second direction X is d3, and compared with the structure shown in FIG. 18, the distance occupied by each memory cell in FIG. 18 along the second direction X is obviously less than the distance d1 occupied by each memory cell in FIG. 18 along the second direction X. In this case, a memory array formed by using the memory cell shown in FIG. 20 has a higher degree of integration. Whether the memory cell shown in FIG. 18 or the memory cell shown in FIG. 20 is used, the distance d1, the distance d2, and the distance d3 are respectively about 2F, and an area occupied by each memory cell is basically about 4F². 1F (F is short for a feature length) is approximately equal to a minimum size that may be prepared by lithography. Compared with existing 6F² to 8F², a transistor structure that is provided in embodiments of this application and that is perpendicular to a substrate may be obtained. The integration density of the memory cell is greatly improved, and the memory capacity is improved.

It should be noted that the foregoing involved first transistor 301 and second transistor 302 may not only be applied to a memory of the 2T0C memory cell, but also may be applied to a memory having more transistors, for example, a memory cell having six transistors. An arrangement manner of the first transistor and the second transistor may be used as an arrangement manner of the two transistors in the memory cell of the six transistors.

In addition, the first transistor and the second transistor may also be applied to other semiconductor apparatuses except the memory, for example, a back-channel logic unit, an image inverter, an AND/OR gate, and a drive unit of a display circuit.

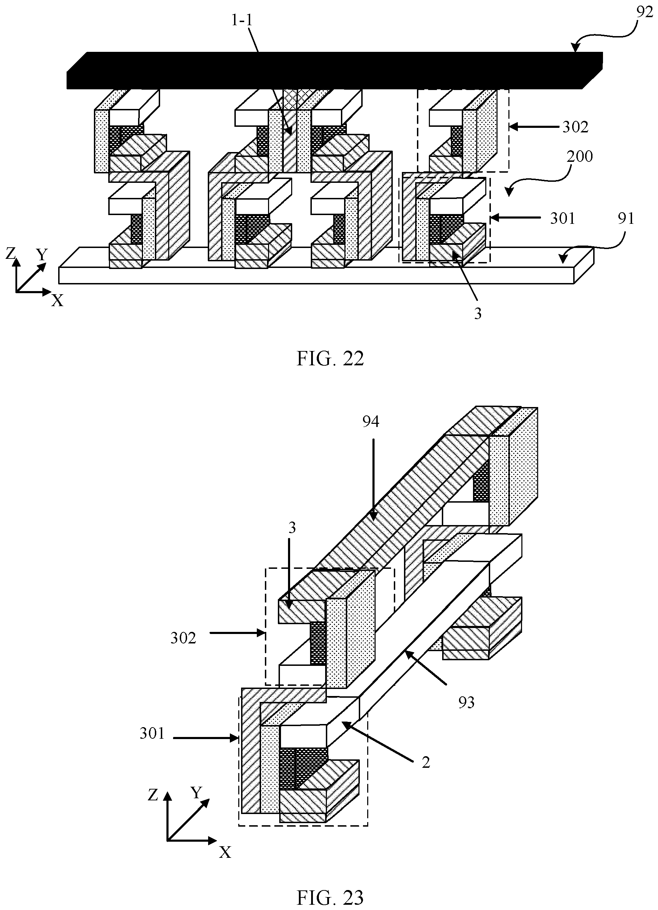

Any layer of memory array in the memory provided in embodiments of this application further includes: a plurality of first signal lines 91. Any first signal line 91 extends along a second direction X. FIG. 22 shows an example of a first signal line 91 extending along a second direction X.

In any layer of memory array, a plurality of first signal lines 91 are disposed on a side of a first transistor 301 that is away from a second transistor 302. Because the first transistor 301 is a read transistor, and the second transistor 302 is a write transistor, the first signal line is either of an RWL or an RBL.

In addition, as shown in FIG. 22, a second electrode 3 of the first transistor 301 in a plurality of memory cells sequentially arranged along the second direction X in each layer of memory array is electrically connected to a same first signal line 91.

Any layer of memory array in the memory provided in embodiments of this application further includes: a plurality of third signal lines 93. Any third signal line 93 extends along a third direction Y FIG. 23 shows an example of a third signal line 93 extending along a third direction Y

In any layer of memory array, because a first transistor 301 is a read transistor, and a second transistor 302 is a write transistor, the third signal line is the other of an RWL or an RBL. In addition, as shown in FIG. 23, a first electrode 2 of the first transistor 301 in a plurality of memory cells sequentially arranged along the third direction Y in each layer of memory array is electrically connected to a same third signal line 93.

Based on the foregoing description of the first signal line 91 and the third signal line 93, with reference to FIG. 22 and FIG. 23, because a second electrode 3 of the first transistor 301 in a plurality of memory cells sequentially arranged along a second direction X in each layer of memory array is electrically connected to a same first signal line 91, the first electrode 2 of the first transistor 301 in the plurality of memory cells sequentially arranged along the third direction Y in each layer of memory array is electrically connected to a same third signal line 93.

From the perspective of a process for forming the memory, compared with the conventional technology, a quantity of RWLs and RBLs may be reduced. This may simplify a structure of the entire memory, and reduce an area occupied by each memory cell.

In terms of performance of the memory, in a process of the read operation, a first level signal may be provided to a plurality of RWLs row by row along the third direction, and a current on each RBL may be detected when the current row of RWLs provide the first level signal. In this way, logic information stored in a plurality of memory cells electrically connected to the current row of RWLs may be read simultaneously, so that the logic information stored in the memory cells may be read row by row, to implement fast reading of the plurality of memory cells in the memory array.

Any layer of memory array in the memory provided in embodiments of this application further includes: a plurality of second signal lines 92. Any two second signal lines 92 extend along a second direction X. FIG. 22 shows an example of a second signal line 92 extending along a second direction X.

In any layer of memory array, a plurality of second signal lines 92 are disposed on a side of a second transistor 302 that is away from a first transistor 301. Because the first transistor 301 is a read transistor, and the second transistor 302 is a write transistor, the second signal line 92 is a WWL.

In addition, as shown in FIG. 22, a gate 1 of the second transistor 302 in a plurality of memory cells sequentially arranged along a second direction X in each layer of memory array is electrically connected to a same second signal line 92. Further, as shown in FIG. 22, if the memory includes two memory cells that are arranged back to back, a common gate 1-1 may be electrically connected to the same second signal line 92.

Any layer of memory array in the memory provided in embodiments of this application further includes: a plurality of fourth signal lines 94. Any fourth signal line 94 extends along a third direction Y FIG. 23 shows an example of a fourth signal line 94 extending along a third direction Y The fourth signal line 94 is a WBL.

In addition, as shown in FIG. 23, a second electrode 3 of the second transistor 302 in a plurality of memory cells sequentially arranged in a third direction Y in each layer of memory array is electrically connected to a same fourth signal line 94.

Based on the foregoing description of the second signal line 92 and the fourth signal line 94, with reference to FIG. 22 and FIG. 23, because the gate 1 of the second transistor 302 in the plurality of memory cells sequentially arranged along the second direction X in each layer of memory array is electrically connected to a same second signal line 92, the second electrode 3 of the second transistor 302 in the plurality of memory cells sequentially arranged along the third direction Y in each layer of memory array is electrically connected to a same fourth signal line 94.

From the perspective of a process for forming the memory, compared with the conventional technology, a quantity of WWLs and WBLs may be reduced. This may simplify a structure of the entire memory, and reduce an area occupied by each memory cell.

In terms of performance of the memory, in a process of the write operation, a first switch signal may be provided to a plurality of WWLs row by row, so that a plurality of rows of second transistors 302 are connected row by row. When the current row of WWLs provide the first switch signal, logic information is simultaneously written to a plurality of memory cells electrically connected to the current row of WWLs through a plurality of WBLs, so that the logic information may be written to the memory cells row by row, to implement fast writing of the plurality of memory cells in the memory array.

In some optional implementations, for example, a memory having a large memory capacity includes two or more layers of memory arrays. In this case, adjacent two layers of memory arrays also have a plurality of different arrangement manners, which are separately described below with reference to the accompanying drawings.

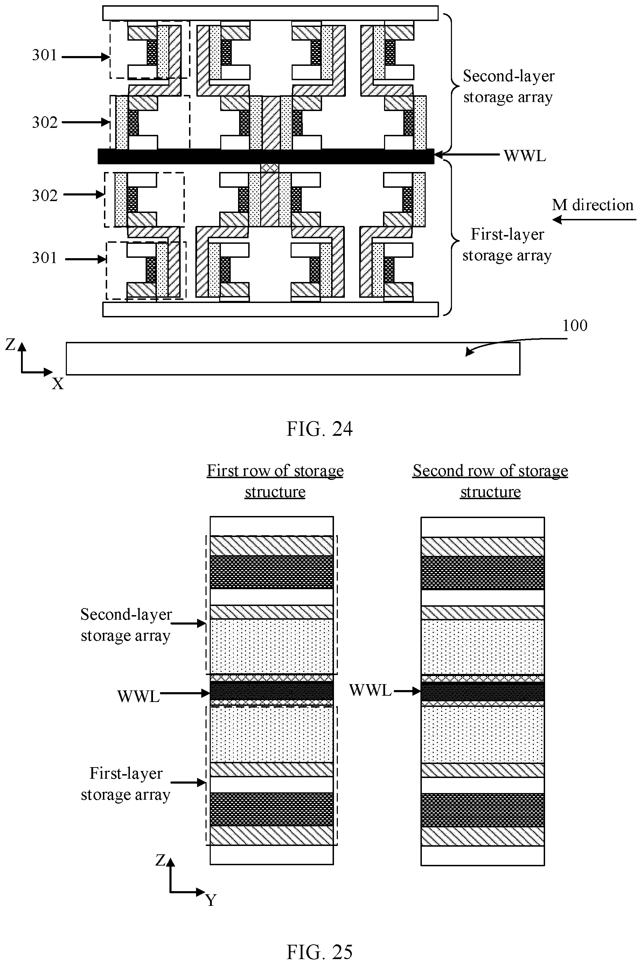

FIG. 24 shows an arrangement manner of two adjacent memory arrays in a multi-layer memory array. The two adjacent memory arrays may be referred to as a first-layer memory array and a second-layer memory array. In the first-layer memory array, second transistors 302 in a plurality of memory cells sequentially arranged along a second direction X are close to second transistors 302 in a plurality of memory cells sequentially arranged along the second direction X in the second-layer memory array.

It may also be understood in this way that using a substrate 100 configured to carry the memory array as a reference, in the first-layer memory array, the first transistor 301 is close to the substrate 100 relative to the second transistor 302, but in the second-layer memory array, the second transistor 302 is close to the substrate 100 relative to the first transistor 301. In this way, a WWL in the first-layer memory array and a corresponding WWL in the second-layer memory array may are a same WWL.

With reference to FIG. 25, the WWL in the first-layer memory array and the corresponding WWL in the second-layer memory array are the same WWL. This is described below

FIG. 25 is a view of an M direction in FIG. 24, and FIG. 25 shows two rows of memory structures arranged along a third direction Y The two rows of memory structures may be defined as a first row of memory structures and a second row of memory structures. In the first row of memory structures, the WWL in the first-layer memory array and the WWL in the second-layer memory structure are the same WWL. Similarly, in the second row of memory structures, the WWL in the first-layer memory array and the WWL in the second-layer memory structure also are the same WWL.

In terms of a process of the memory, because the WWL in the first-layer memory array and the corresponding WWL in the second-layer memory array are the same WWL, a quantity of metal layers used to form the WWL may be reduced, a preparing cost may be reduced, a preparing process may be simplified, and space utilization may be improved, to further improve an integration density of memory cells.

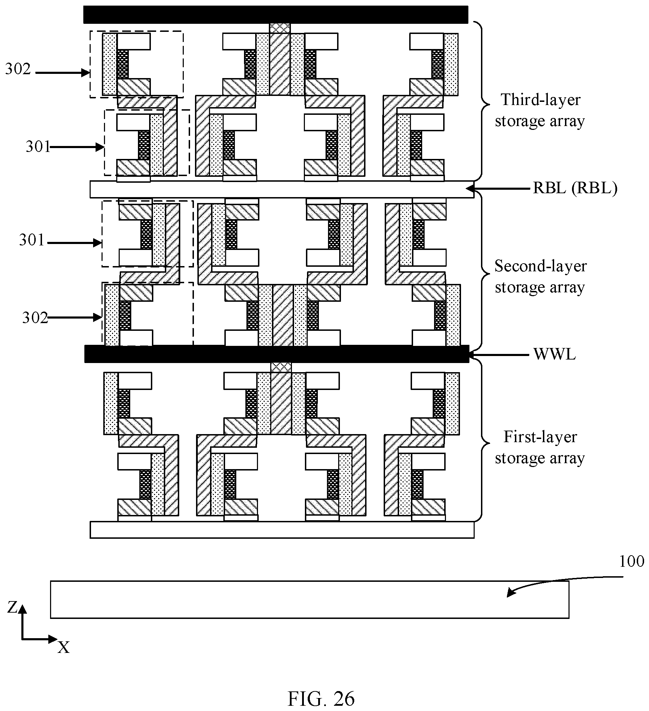

Based on the structure shown in FIG. 24, when a third-layer memory array is further included, as shown in FIG. 26, the third-layer memory array the second memory array are adjacent to each other, and in the third-layer memory array, the first transistor 301 is close to the substrate 100 relative to the second transistor 302. In this way, an RWL in the third-layer memory array and an opposite RWL in the second-layer memory array are a same RWL, or an RWL in the third-layer memory array and an opposite RBL in the second-layer memory array are a same RBL.

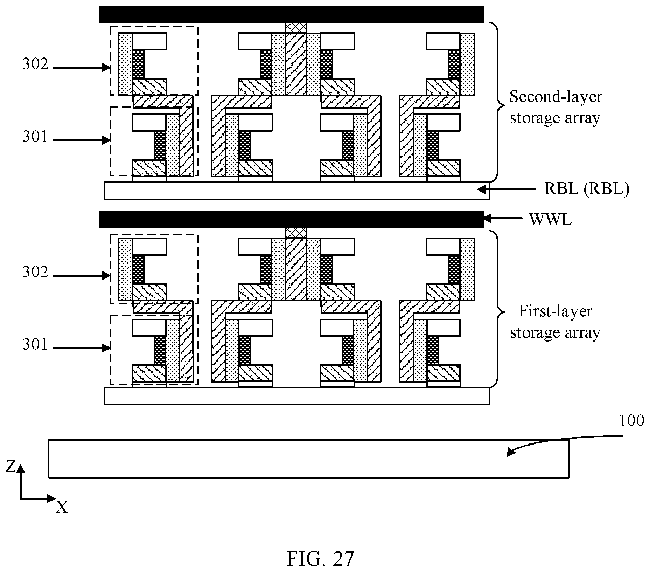

Based on the structure shown in FIG. 24, if there is still a fourth-layer memory array, an arrangement manner of the fourth-layer memory array and a third-layer memory array adj acent to the fourth-layer memory array may be set with reference to the arrangement manner of the first-layer memory array and the second-layer memory array. Details are not described herein again. FIG. 27 shows another arrangement manner of two adjacent memory arrays. The two adjacent memory arrays also include a first-layer memory array and a second-layer memory array. In the first-layer memory array, second transistors 302 in a plurality of memory cells sequentially arranged along a second direction X are close to first transistors 301 in a plurality of memory cells sequentially arranged along a second direction X in the second-layer memory array.

It may also be understood that using a substrate 100 configured to carry the memory array as a reference, in the first-layer memory array, the first transistor 301 is close to the substrate 100 relative to the second transistor 302. Similarly, in the second-layer memory array, the first transistor 301 is close to the substrate 100 relative to the second transistor 302. In this way, the WWL in the first-layer memory array and the opposite RWL in the second-layer memory array are two word lines independent of each other, or the WWL in the first-layer memory array and the opposite RBL in the second-layer memory array are two signal lines independent of each other. Further, a dielectric layer may be disposed between the WWL and the RWL or between the WWL and the RBL, and the first-layer memory array and the second-layer memory array are separated through the dielectric layer.

In some optional implementations, a material of the dielectric layer may be one or more of insulating materials such as SiO₂ (silica), Al₂O₃ (alumina), HfO₂ (hafnium dioxide), ZrO₂ (zirconia), TiO₂ (titanium dioxide), Y₂O₃ (yttrium trioxide), and Si₃N₄ (silicon nitride).

The dielectric layer may be a single-layer structure, or may be a multi-layer laminated structure. In addition, a material of the single-layer structure and a material of each layer in the multi-layer laminated structure may be one or more of SiO₂, Al₂O₃, HfO₂, ZrO₂, TiO₂, Y₂O₃, and Si₃N₄. Based on the structure shown in FIG. 27, if there is still a third-layer memory array, an arrangement manner of the third-layer memory array and a second-layer memory array adjacent to the third-layer memory array may be set with reference to the arrangement manner of the first-layer memory array and the second-layer memory array. Details are not described herein again.

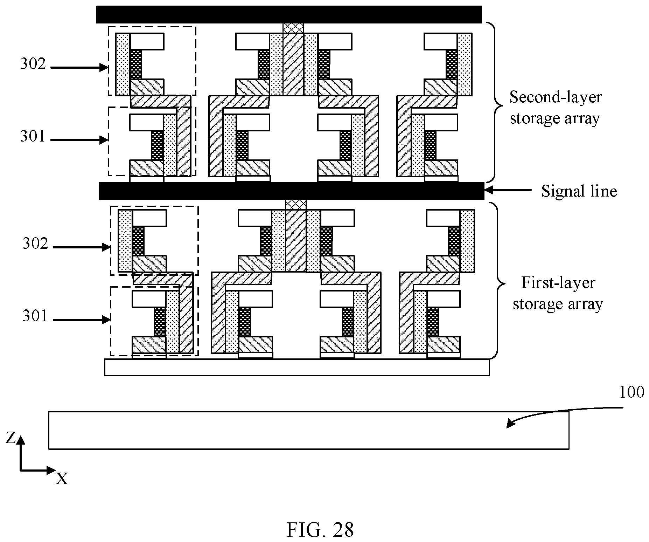

FIG. 28 shows another arrangement manner of two adjacent memory arrays. The two adjacent memory arrays also include a first-layer memory array and a second-layer memory array. A structure similar to the structure shown in FIG. 27 is that in the first-layer memory array, second transistors 302 in a plurality of memory cells sequentially arranged along a second direction X are close to first transistors 301 in a plurality of memory cells sequentially arranged along a second direction X in the second-layer memory array. A structure different from the structure shown in FIG. 27 is that a WWL in the first-layer memory array and an opposite RWL in the second-layer memory array are a same word line, or a WWL in the first-layer memory array and an opposite RBL in the second-layer memory array are a same signal line.

In terms of a process of the memory, the WWL in the first-layer memory array and the opposite RWL in the second-layer memory array are the same word line, or the WWL in the first-layer memory array and the opposite RBL in the second-layer memory array share the same signal line. Similarly, in this way, a quantity of metal layers may be reduced, a preparing cost may be reduced, a preparing process may be simplified, and space utilization may be improved, to further improve an integration density of memory cells.

Based on the structure shown in FIG. 28, if there is still a third-layer memory array, an arrangement manner of the third-layer memory array and a second-layer memory array adjacent to the third-layer memory array may be set with reference to the arrangement manner of the first-layer memory array and the second-layer memory array. Details are not described herein again.

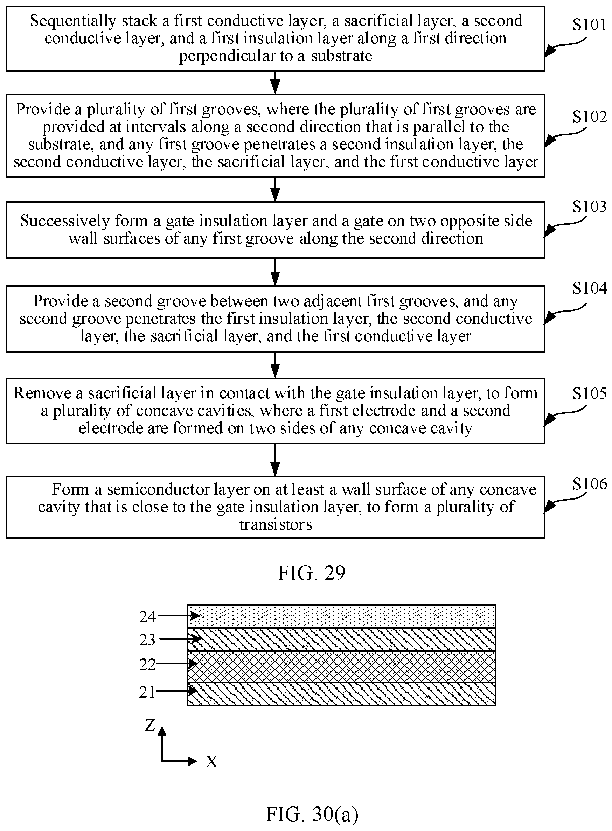

Embodiments of this application further provide a forming method for a transistor. FIG. 29 is a flowchart block diagram of preparing a plurality of transistors, and FIG. 30(a) to FIG. 30(f) are a diagram of a structure corresponding to each step performed when the plurality of transistors are prepared. The following explains the forming method for a transistor with reference to FIG. 29 and FIG. 30(a) to FIG. 30(f).

In step S101 in FIG. 29 and FIG. 30(a), a first conductive layer 21, a sacrificial layer 22, a second conductive layer 23, and a first insulation layer 24 are sequentially stacked along a first direction Z perpendicular to a substrate.

The first conductive layer 21 and the second conductive layer 23 may be made of a metal material. For example, one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver) may be selected.

A material of the sacrificial layer 22 may be Si (silicon), Si₃N₄ (silicon nitride), Al₂O₃ (alumina), SiO (silicon oxide), Ge (germanium), silicon germanium compound, or the like.

A material of the first insulation layer 24 may be one or more of insulating materials such as SiO₂ (silica), Al₂O₃ (alumina), HfO₂ (hafnium dioxide), ZrO₂ (zirconia), TiO₂ (titanium dioxide), Y₂O₃ (yttrium trioxide), and Si₃N₄ (silicon nitride).

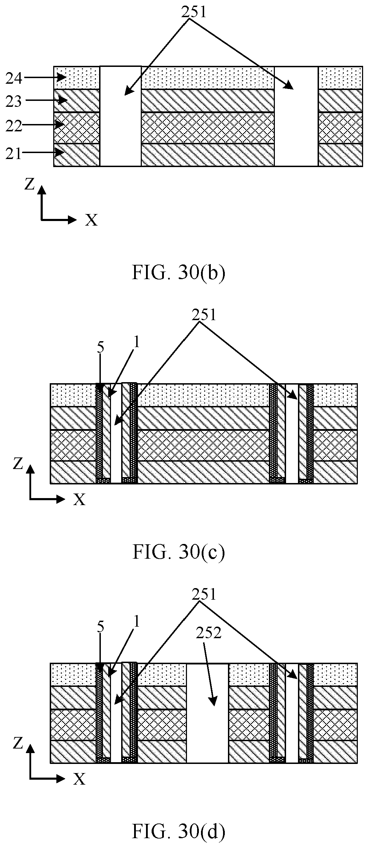

In step S102 in FIG. 29 and FIG. 30(b), a plurality of first grooves 251 are provided, the plurality of first grooves 251 are provided at intervals along a second direction X that is parallel to the substrate, and any first groove 251 runs through the first insulation layer 24, the second conductive layer 23, the sacrificial layer 22, and the first conductive layer 21.

When the first groove 251 is provided, the groove may be provided by using an etching process. In step S103 in FIG. 29 and FIG. 30(c), a gate insulation layer 5 and a gate 1 are sequentially formed on two opposite side wall surfaces of any first groove 251 along a second direction X.

In step S104 in FIG. 29 and FIG. 30(d), a second groove 252 is provided between two adjacent first grooves 251, and any second groove 252 runs through the first insulation layer 24, the second conductive layer 23, the sacrificial layer 22, and the first conductive layer 21.

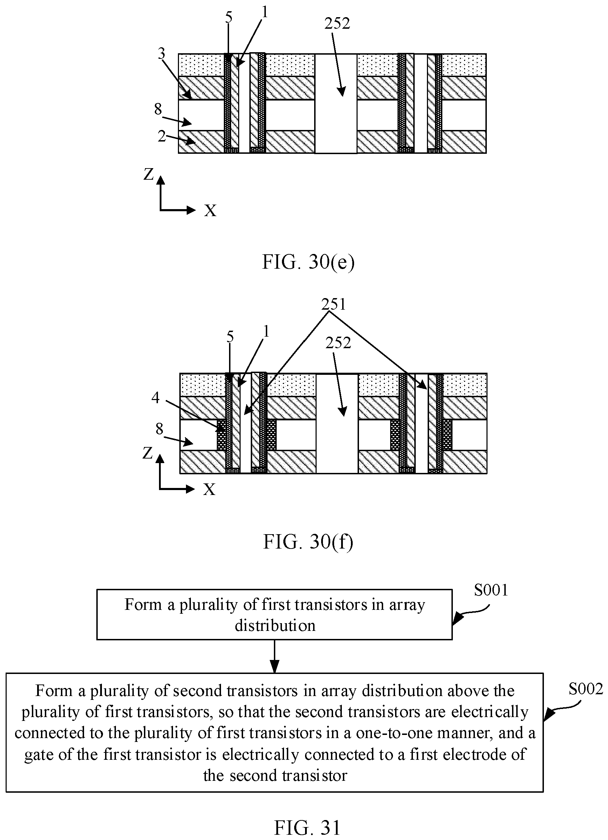

In step S105 in FIG. 29 and FIG. 30(e), a sacrificial layer in contact with the gate insulation layer 5 is removed, to form a plurality of concave cavities 8, and a first electrode 2 and a second electrode 3 are formed on two sides of any concave cavity 8.

In step S106 in FIG. 29 and FIG. 30(f), a semiconductor layer 4 is formed on at least a wall surface close to the gate insulation layer 5 of any concave cavity 8, to prepare a plurality of transistors arranged along the second direction X.

Embodiments of this application further provide a forming method for a memory. As shown in FIG. 31, FIG. 31 is a flowchart block diagram of preparing any layer of memory array of the memory. The forming method for any layer of memory array includes the following steps.

Step S001: Form a plurality of first transistors in array distribution.

In some optional implementations, a plurality of first transistors may be directly formed on a substrate, and a memory thus formed is referred to as a stand-alone memory. In some other optional implementations, a logic control circuit is first formed on the substrate, and then a plurality of first transistors are formed on the logic control circuit through a BEOL. A memory thus formed is referred to as an embedded memory.

Step S002: Form a plurality of second transistors in array distribution above the plurality of first transistors, so that the second transistors are electrically connected to the plurality of first transistors in a one-to-one manner, and a gate of the first transistor is electrically connected to a first electrode of the second transistor.

The following describes in detail a process of preparing a memory by using the method for preparing a transistor shown in FIG. 29 and FIG. 30(a) to FIG. 30(f).

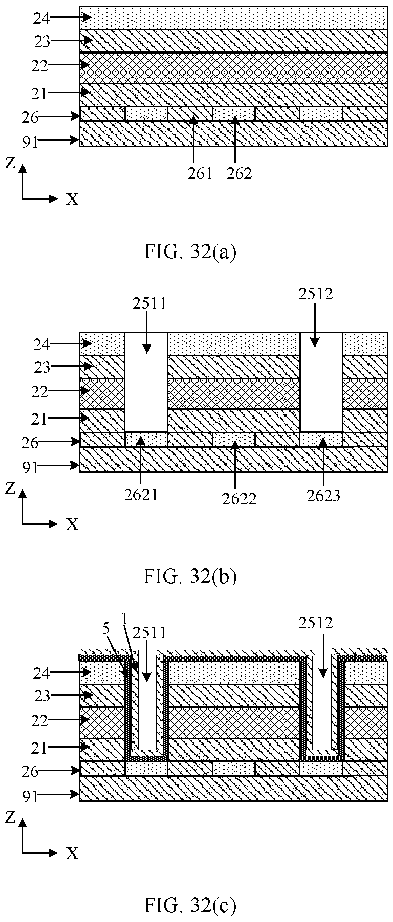

In FIG. 32(a), a first signal line 91, a pattern layer 26, a first conductive layer 21, a sacrificial layer 22, a second conductive layer 22, and a first insulation layer 24 are sequentially stacked along a first direction Z perpendicular to a substrate. The pattern layer 26 includes a metal connection layer 261 and a second insulation layer 262 that are provided at intervals along a second direction X. Materials of the first conductive layer 21, the sacrificial layer 22, the second conductive layer 22, and the first insulation layer 24 have been described above, and are not described herein again. In FIG. 32(b), a plurality of first grooves provided at intervals along the second direction X, and the first grooves pass through the first insulation layer 24, the second conductive layer 22, the sacrificial layer 22, and the first conductive layer 21.

For example, with reference to FIG. 32(b), the second insulation layer may include a second insulation layer 2621, a second insulation layer 2622, and a second insulation layer 2623 that are arranged along the second direction X. When the first groove is provided, a first groove 2511 is provided at a position opposite to the second insulation layer 2621, and the first groove 2512 is provided at a position opposite to the second insulation layer 2623. Integrity of the first conductive layer 21, the sacrificial layer 22, the second conductive layer 22, and the first insulation layer 24 that are opposite to the second insulation layer 2622 is reserved for providing the second groove. In FIG. 32(c), the first groove 2511 and the first groove 2512 are sequentially filled with a dielectric material and a conductive material, to sequentially form a gate insulation layer 5 and a gate 1 on two opposite wall surfaces of the first groove 2511 and the first groove 2512. However, it should be noted that the gates 1 on the two opposite wall surfaces of any first groove cannot be in contact, to avoid electrical connection between the formed two transistors. In other words, there is a spacing between the gates 1 on the two opposite wall surfaces of any first groove along the second direction X.

When forming the gate insulation layer 5 and the gate 1, a deposition process such as physical vapor deposition (physical vapor deposition, PVD), chemical vapor deposition (chemical vapor deposition, CVD), or electro-chemical deposition (electro-chemical deposition, ECD) may be selected.

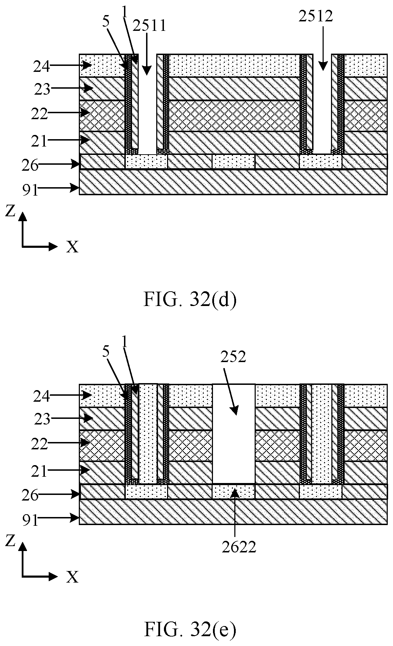

In FIG. 32(d), when the dielectric material and the conductive material are deposited, a bottom surface of the first groove 2511, a bottom surface of the first groove 2512, and a surface of the first insulation layer 24 are also covered with the dielectric material and the conductive material. Therefore, as shown in FIG. 32(c), processing needs to be performed on the bottom surface of the first groove 2511, the bottom surface of the first groove 2512, and the surface of the first insulation layer 24, for example, dry etching, to remove the dielectric material and the conductive material on the bottom surface of the first groove 2511, the bottom surface of the first groove 2512, and the surface of the first insulation layer 24, and to obtain the structure shown in FIG. 32(d).

In FIG. 32(e), a second groove is provided between two adjacent first grooves, so that the second groove runs through the first insulation layer 24, the second conductive layer 22, the sacrificial layer 22, and the first conductive layer 21.

Still with reference to FIG. 32(e), the second groove 252 may be provided at a position opposite to the second insulation layer 2622. The second groove 252 is provided at the position opposite to the second insulation layer 2622 because in the step shown in FIG. 32(c), the gate insulation layer 5 and the gate 1 are formed on two opposite wall surfaces of the first groove, so that transistors are formed on two sides of the first groove. For example, as shown in FIG. 32(e), if the second groove 252 is not provided, the transistor on the right side of the first groove 2511 and the transistor on the left side of the first groove 2512 are jointly connected. Therefore, the second groove needs to be provided between two adjacent first grooves.

In addition, before the second groove 252 is provided, the remaining space of the first groove 252 in which the gate insulation layer 5 and the gate 1 have been formed may be filled with the dielectric material. In this way, the gate insulation layer 5 and the gate 1 in the first groove are not contaminated when the second groove 252 is provided. Certainly, the remaining space of the first groove 252 may be filled after the second groove 252 is provided. When the second groove 252 is provided, the second groove 252 may be formed by using the same process of the first groove, for example, an etching process.

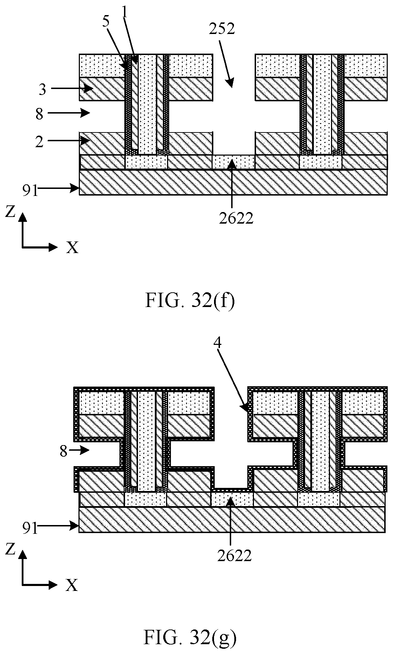

In FIG. 32(f), a sacrificial layer in contact with the gate insulation layer 5 is removed, to form a plurality of concave cavities 8. In this way, conductive layers on two sides of the concave cavity 8 form the first electrode 2 and the second electrode 3.

In some optional implementations, the etching process may be selected to remove the sacrificial layer. For example, when a material of the sacrificial layer is silicon oxide, a hydrofluoric acid etching medium may be used for etching.

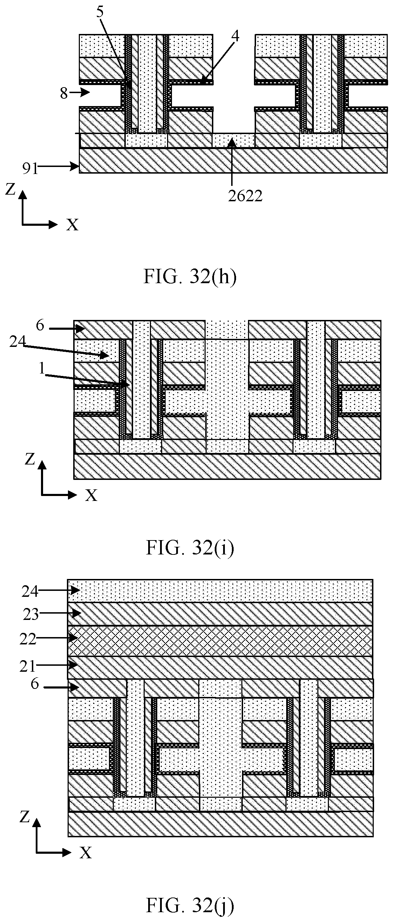

In FIG. 32(g) and FIG. 32(h), a semiconductor layer 4 is formed in the concave cavity 8.

In an optional implementation, the semiconductor layer 4 may be formed by using a deposition process such as PVD, CVD, or ECD. In this way, as shown in FIG. 32(g), a semiconductor material is deposited on each wall surface of the concave cavity 8 and on the surface of the first insulation layer. As shown in FIG. 32(h), processing needs to be performed on positions such as the surface of the first insulation layer, and only the semiconductor layer 4 on each wall surface in the concave cavity 8 is reserved, to obtain the structure shown in FIG. 32(h), or only the semiconductor layer 4 in contact with the gate insulation layer 5 in the concave cavity 8 is reserved.

Based on the foregoing description, a plurality of first transistors 301 may be prepared, and a first signal line 91 is electrically connected to the second electrode 3 of the first transistor 301 that is close to the first signal line 91, so that the first signal line 91 is either of an RBL or an RWL.

As shown in FIG. 32(i), a plurality of metal layers 6 provided at intervals along the second direction X are formed on the surface of the first insulation layer 24, and each metal layer 6 is electrically connected to the gate 1 of the corresponding first transistor 301.

It should be noted that the metal layer 6 may be formed after the first transistor 301 is formed, or may be formed when the first transistor 301 is formed. For example, the metal layer may be formed when the gate 1 shown in FIG. 32(c) is formed. It may be understood in this way that the gate 1 and the metal layer are simultaneously formed, so that the gate and the metal layer in an integral structure.

In FIG. 32(j), the first conductive layer 21, the sacrificial layer 22, the second conductive layer 22, and the first insulation layer 24 are sequentially stacked on the metal layer 6 along the first direction X.

Materials of the first conductive layer 21, the sacrificial layer 22, the second conductive layer 22, and the first insulation layer 24 may be the same as materials of the first conductive layer 21, the sacrificial layer 22, the second conductive layer 23, and the first insulation layer 24 shown in FIG. 32(a).

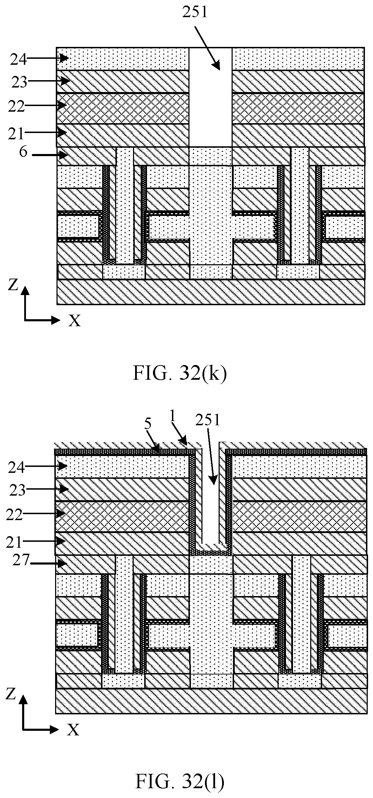

In FIG. 32(k), a first groove 251 is provided, and any first groove 251 runs through the first insulation layer 24, the second conductive layer 23, the sacrificial layer 22, and the first conductive layer 21.

It should be noted that a providing position of the first groove 251 shown in FIG. 32(k) corresponds to a position of the second groove 252 shown in FIG. 32(e). It may also be understood in this way that along a first direction Z, the first groove 251 shown in FIG. 32(k) is located directly above the second groove 252 shown in FIG. 32(e).

In FIG. 32(l), the gate insulation layer 5 and the gate 1 that are sequentially arranged along the second direction X are formed on two opposite sides of the first groove 251.

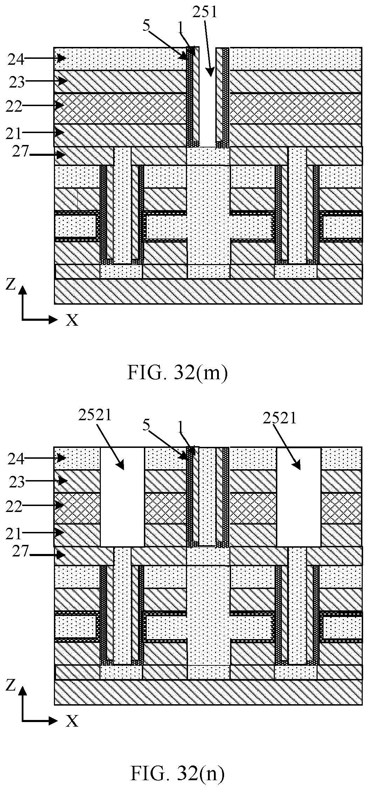

The method in which the gate insulation layer 5 and the gate 1 that are sequentially arranged along the second direction X are formed on two opposite sides of the first groove 251 may be the same as the method for preparing the gate insulation layer 5 and the gate 1 of the first transistor, and the gate insulation layer 5 and the gate 1 of the first transistor may be prepared by using a deposition process such as PVD, CVD, or ECD. In this way, when the dielectric material and the conductive material are deposited, a bottom surface of the first groove 251 and a surface of the first insulation layer 24 are also covered with the dielectric material and the conductive material. Therefore, as shown in FIG. 32(l), processing needs to be performed on the bottom surface of the first groove 251 and the surface of the first insulation layer 24, for example, dry etching, to remove the dielectric material and the conductive material on the bottom surface of the first groove 2511 and the surface of the first insulation layer 24, and to obtain the structure shown in FIG. 32(m).

In FIG. 32(n), a second groove is provided between two adjacent first grooves, so that the second groove runs through the first insulation layer 24, the second conductive layer 22, the sacrificial layer 22, and the first conductive layer 21.

It should be noted that a providing position of the second groove 2521 shown in FIG. 32(n) corresponds to a position of the first groove 2511 shown in FIG. 32(a). It may also be understood in this way that along the first direction Z, the second groove 2521 shown in FIG. 32(n) is located directly above the first groove 2511 shown in FIG. 32(a). Similarly, a providing position of the second groove 2522 shown in FIG. 32(n) corresponds to a position of the first groove 2512 shown in FIG. 32(a). It may also be understood in this way that along the first direction Z, the second groove 2522 shown in FIG. 32(n) is located directly above the first groove 2512 shown in FIG. 32(a).

In addition, before providing the second groove, the remaining space of the first groove in which the gate insulation layer 5 and the gate 1 have been formed may be filled with the dielectric material. In this way, the gate insulation layer 5 and the gate 1 in the first groove are not contaminated when the second groove is provided. Certainly, the remaining space of the first groove may be filled after the second groove is provided.

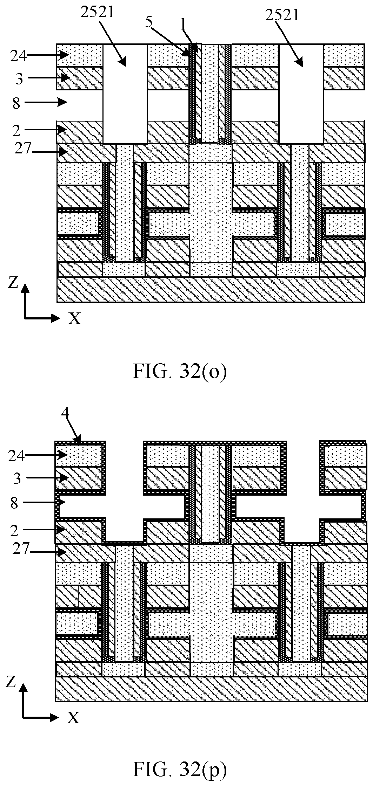

In FIG. 32(o), the sacrificial layer in contact with the gate insulation layer 5 is removed, to form a plurality of concave cavities 8. In this way, conductive layers on two sides of the concave cavity 8 form the first electrode 2 and the second electrode 3.

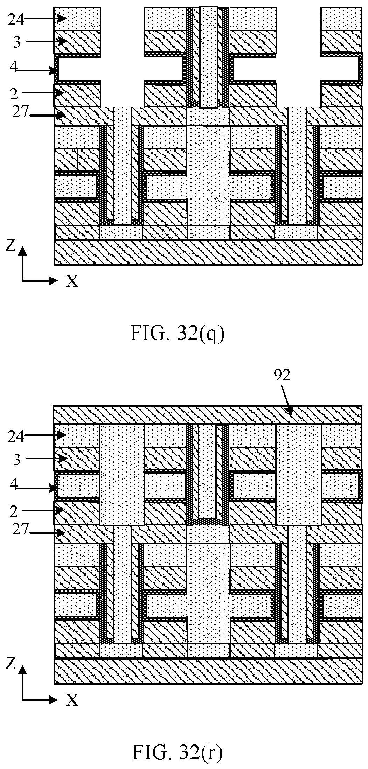

In (p) and FIG. 32(q), a semiconductor layer 4 is formed in the concave cavity 8.

In an optional implementation, the semiconductor layer 4 may be formed by using a deposition process such as PVD, CVD, or ECD. In this way, as shown in FIG. 32(p), a semiconductor material is deposited on each wall surface of the concave cavity 8 and on the surface of the first insulation layer. As shown in FIG. 32(q), processing needs to be performed on positions such as the surface of the first insulation layer, and only the semiconductor layer 4 on each wall surface in the concave cavity 8 is reserved, to obtain the structure shown in FIG. 32(q), or only the semiconductor layer 4 in contact with the gate insulation layer 5 in the concave cavity 8 is reserved.

In this way, a plurality of second transistors arranged along the second direction X may be formed. In FIG. 32(r), a second signal line 92 is formed on the first insulation layer 24, and the second signal line 92 is electrically connected to the gate of the second transistor. The second signal line 92 is a WWL.

Based on the foregoing method for preparing a plurality of memory cells, it may be learned that two transistors of each prepared memory cell are the foregoing 2T reversely disposed memory cells. In other words, two memory cells whose transistors are reversely disposed. In addition, two adjacent second transistors share a gate to form a common gate.

In the descriptions of this specification, the described specific features, structures, materials, or characteristics may be combined in a proper manner in any one or more of the embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor apparatus, comprising:
a substrate;
a first transistor; and
a second transistor, wherein the second transistor is electrically connected to the first transistor, the first transistor and the second transistor are arranged along a first direction perpendicular to the substrate, and the first transistor and the second transistor each comprise a gate, a semiconductor layer, a first electrode, and a second electrode; and
in either of the first transistor and the second transistor, the gate and the semiconductor layer are arranged along a second direction parallel to the substrate, and the first electrode and the second electrode are disposed on two sides of the semiconductor layer along the first direction and are electrically connected to the semiconductor layer respectively.

2. The semiconductor apparatus according to claim 1, wherein either of the first transistor and the second transistor further comprises a gate insulation layer, and the gate, the gate insulation layer, and the semiconductor layer are sequentially stacked; and
in at least one of the first transistor and the second transistor, a part of a surface of the gate insulation layer away from the gate is covered by the semiconductor layer, and both the first electrode and the second electrode are formed on the gate insulation layer.

3. The semiconductor apparatus according to claim 2, wherein a surface of the first electrode opposite to the second electrode is a first wall surface, a surface of the second electrode opposite to the first electrode is a second wall surface, the first wall surface, the second wall surface, and the surface of the gate insulation layer away from the gate form a concave cavity, and the semiconductor layer is disposed at a position that is of the concave cavity and that is in contact with the surface of the gate insulation layer.

4. The semiconductor apparatus according to claim 3, wherein the semiconductor layer is formed both at a position that is of the concave cavity and that is in contact with the first wall surface and at a position that is of the concave cavity and that is in contact with the second wall surface.

5. The semiconductor apparatus according to claim 1, wherein either of the first transistor and the second transistor further comprises a gate insulation layer, and the gate, the gate insulation layer, and the semiconductor layer are sequentially stacked; and
in at least one of the first transistor and the second transistor, both the first electrode and the second electrode are formed at the semiconductor layer.

6. The semiconductor apparatus according to any one of claims 1 to 5, wherein in the at least one of the first transistor and the second transistor,
an insulation layer for allowing a current between the first electrode and the semiconductor layer to pass is formed at an interface between the first electrode and the semiconductor layer; and/or
an insulation layer for allowing a current between the second electrode and the semiconductor layer to pass is formed at an interface between the second electrode and the semiconductor layer.

7. The semiconductor apparatus according to any one of claims 1 to 6, wherein an arrangement direction of the gate and the semiconductor layer in the first transistor is opposite to an arrangement direction of the gate and the semiconductor layer in the second transistor.

8. The semiconductor apparatus according to claim 7, wherein a surface of the first electrode and a surface of the second electrode that are away from the gate in the first transistor are flush with a surface of the first electrode and a surface of the second electrode that are close to the gate in the second transistor.

9. The semiconductor apparatus according to claim 7, wherein a surface of the first electrode and a surface of the second electrode that are away from the gate in the first transistor are flush with a surface of the gate away from the first electrode and the second electrode in the second transistor.

10. The semiconductor apparatus according to any one of claims 1 to 9, wherein the first electrode of the second transistor is disposed close to the first transistor; and
a metal layer is formed between the first transistor and the second transistor, and the first transistor is electrically connected to the second transistor through the metal layer.

11. The semiconductor apparatus according to any one of claims 1 to 10, wherein the semiconductor apparatus is a memory, the memory comprises a first memory cell, the first memory cell comprises the first transistor and the second transistor, and the gate of the first transistor is electrically connected to the first electrode of the second transistor.

12. The semiconductor apparatus according to claim 11, wherein the memory further comprises a second memory cell, and the first memory cell and the second memory cell are adjacent to each other and are arranged along the second direction;
the second memory cell comprises a third transistor and a fourth transistor electrically connected to the third transistor;
the third transistor and the fourth transistor are arranged along the first direction, and the third transistor and the fourth transistor each comprise a second gate, a second semiconductor layer, a 2^{nd} first electrode, and a 2^{nd} second electrode;
in either of the third transistor and the fourth transistor, the second gate and the second semiconductor layer are arranged along the second direction, and the 2^{nd} first electrode and the 2^{nd} second electrode are disposed on two sides of the second semiconductor layer along the first direction and are electrically connected to the second semiconductor layer respectively; and
the first memory cell and the second memory cell are disposed back to back, and the gate of the second transistor is in contact with the second gate of the fourth transistor, to form a common gate.

13. The semiconductor apparatus according to claim 11 or 12, wherein the memory further comprises:
a first signal line, disposed on a side of the first transistor away from the second transistor, wherein the first signal line is either of a read bit line and a read word line; and
a second signal line, disposed on a side of the second transistor away from the first transistor, wherein both the first signal line and the second signal line extend along the second direction, and the second signal line is a write word line, wherein
in a memory array of the memory, second electrodes of first transistors that are disposed away from second transistors in a plurality of memory cells sequentially arranged along the second direction are electrically connected to a same first signal line; and
in the memory array of the memory, gates of second transistors in the plurality of memory cells sequentially arranged along the second direction are electrically connected to a same second signal line.

14. The semiconductor apparatus according to claim 13, wherein the memory further comprises:
a third signal line, wherein the third signal line is the other of the read bit line and the read word line; and
a fourth signal line, wherein the fourth signal line is a write bit line, both the third signal line and the fourth signal line extend along a third direction, and the second direction is orthogonal to the third direction, wherein
in the memory array of the memory, first electrodes of the first transistors that are disposed close to the second transistors in the plurality of memory cells sequentially arranged along the third direction are electrically connected to a same third signal line; and
in the memory array of the memory, second electrodes of the second transistors that are disposed away from the first transistor in the plurality of memory cells sequentially arranged along the third direction are electrically connected to a same fourth signal line.

15. The semiconductor apparatus according to claim 13 or 14, wherein the memory comprises a first-layer memory array and a second-layer memory array that are adjacent to each other;
the first transistors in the plurality of memory cells sequentially arranged along the second direction in the first-layer memory array are close to the first transistors in the plurality of memory cells sequentially arranged along the second direction in the second-layer memory array; and
the first signal line in the first-layer memory array and the opposite first signal line in the second-layer memory array are a same signal line.

16. The semiconductor apparatus according to claim 13 or 14, wherein the memory comprises a first-layer memory array and a second-layer memory array that are adjacent to each other;
the second transistors in the plurality of memory cells sequentially arranged along the second direction in the first-layer memory array are close to the second transistors in the plurality of memory cells sequentially arranged along the second direction in the second-layer memory array; and
the second signal line in the first-layer memory array and the opposite second signal line in the second-layer memory array are a same signal line.

17. The semiconductor apparatus according to claim 13 or 14, wherein the memory comprises a first-layer memory array and a second-layer memory array that are adjacent to each other;
the second transistors in the plurality of memory cells sequentially arranged along the second direction in the first-layer memory array are close to the first transistors in the plurality of memory cells sequentially arranged along the second direction in the second-layer memory array; and
the first signal line in the first-layer memory array and the opposite second signal line in the second-layer memory array are a same signal line;
or
the first signal line in the first-layer memory array and the opposite second signal line in the second-layer memory array are signal lines independent of each other.

18. An electronic device, comprising:
a circuit board; and
the semiconductor apparatus according to any one of claims 1 to 17, wherein the circuit board is electrically connected to the semiconductor apparatus.

19. The electronic device according to claim 18, wherein the electronic device further comprises:
a logic processing circuit, wherein the logic processing circuit is disposed on the substrate, and the semiconductor apparatus is disposed on the logic processing circuit.

20. A forming method for a transistor, comprising:
sequentially stacking a first conductive layer, a sacrificial layer, and a second conductive layer along a first direction perpendicular to a substrate;
providing a first groove that runs through the second conductive layer, the sacrificial layer, and the first conductive layer;
sequentially forming a gate insulation layer and a gate on a side wall surface of the first groove along a second direction parallel to the substrate;
removing the sacrificial layer in contact with the gate insulation layer, to form a concave cavity, wherein a first electrode and a second electrode are formed on two sides of the concave cavity; and
forming a semiconductor layer on at least a wall surface of the concave cavity close to the gate insulation layer, to form a transistor on the substrate.

21. The forming method for a transistor according to claim 20, wherein the forming the semiconductor layer on at least a wall surface of the concave cavity close to the gate insulation layer comprises:
forming the semiconductor layer on a wall surface of the concave cavity close to the gate insulation layer, on a first wall surface of the first electrode, and on a second wall surface of the second electrode, wherein the first wall surface is a surface of the first electrode opposite to the second electrode, and the second wall surface is a surface of the second electrode opposite to the first electrode.

22. A forming method for a memory, comprising: forming at least one layer of memory array on a substrate, wherein a forming method for any layer of memory array comprises:
forming a plurality of first transistors in array distribution, wherein the first transistor is prepared by using the forming method according to claim 20 or 21; and
forming a plurality of second transistors in array distribution above the plurality of first transistors, wherein the second transistor is prepared by using the preparing method according to claim 20 or 21, the second transistors are electrically connected to the plurality of first transistors in a one-to-one manner, and the gate of the first transistor is electrically connected to the first electrode of the second transistor.

23. The forming method for a memory according to claim 22, wherein
when the first groove is provided, the method comprises: providing a plurality of first grooves at intervals along the first direction;
when a gate insulation layer and a gate are sequentially formed on a side wall surface of the first groove, the method comprises: sequentially forming the gate insulation layer and the gate on two side wall surfaces of any first groove that are opposite to each other; and
before removing the sacrificial layer in contact with the gate insulation layer, the forming method further comprises:
providing a second groove between two adjacent first grooves.

24. The forming method for a memory according to claim 23, wherein when the plurality of second transistors are formed, a providing position of the first groove is located directly above the second groove when the plurality of first transistors are formed.

25. The forming method for a memory according to any one of claims 22 to 24, wherein when the first transistor is formed, the method further comprises:
forming a metal layer on the gate, where the metal layer is in contact with the gate, to cause the gate of the first transistor and a first electrode of the second transistor to be electrically connected through the metal layer.
